# EUROPEAN PATENT APPLICATION

(11) **EP 4 776 330 A1**
(43) Date of publication of application: **15.07.2026**
(21) Application number: 24862908.1
(22) Date of filing: 06.09.2024
(51) Int. Cl.: H01L 21/312

(54) **COMPOSITION FOR FORMING PROTECTIVE FILM, PROTECTIVE FILM, METHOD FOR MANUFACTURING SUBSTRATE, AND METHOD FOR MANUFACTURING SEMICONDUCTOR DEVICE**

(30) Priority: 08.09.2023 JP 2023145746
(71) Applicant: Nissan Chemical Corporation, Tokyo 103-6119 (JP)
(72) Inventor: NISHITA Tokio, Toyama-shi, Toyama 939-2792 (JP); KINOSHITA Kazuhiko, Toyama-shi, Toyama 939-2792 (JP); TANAKA Takumi, Toyama-shi, Toyama 939-2792 (JP); ENDO Yuki, Toyama-shi, Toyama 939-2792 (JP)
(74) Representative: Hoffmann Eitle
(86) International application number: PCT/JP2024/032047
(87) International publication number: WO 2025/053259

(57) **Abstract**

A protective-film forming composition against a semiconductor wet etching solution, including: component (A): a film-forming component; component (B): a compound selected from the group consisting of condensed tannin (b1) obtained by polymerizing a compound having a flavanol skeleton, hydrolyzable tannin (b2) obtained by ester-bonding an aromatic compound of gallic acid or ellagic acid to a sugar, and a flavonoid (b3) derived from a compound having a flavanone skeleton structure; and component (C): a solvent.

## Description

### Technical Field

The present invention relates to a protective-film forming composition for forming a protective film having excellent resistance particularly to a semiconductor wet etching solution in a lithography process in semiconductor manufacturing. The present invention also relates to a method for manufacturing a substrate with a resist pattern using the protective-film forming composition, and a method for manufacturing a semiconductor device.

### Background Art

In semiconductor manufacturing, a lithography process of providing a resist underlayer film between a substrate and a resist film formed on the substrate and forming a resist pattern having a desired shape is widely known. The substrate is processed after the resist pattern is formed. Dry etching is mainly used as the process, but wet etching may be used depending on the type of substrate. Patent Literature 1 discloses a resist underlayer film material having resistance to alkaline hydrogen peroxide water.

### Citation List

### Patent Literature

Patent Literature 1: JP 2018-173520 A

### Summary of Invention

### Technical Problem

When a protective film for a semiconductor substrate is formed using a protective-film forming composition, and processing of a base substrate is performed by wet etching using the protective film as an etching mask, the protective film is required to have a satisfactory masking function (that is, a masked portion can protect the substrate) with respect to a semiconductor wet etching solution. Furthermore, in the production process for semiconductor devices, when the amount of a sublimate generated from the protective film is large, problems such as contamination of the top plate and the inside of pipes of a baker used at the time of firing occur.

The present invention has been made in view of the above-described circumstances, and an object of the present invention is to provide a protective-film forming composition capable of forming a protective film having excellent resistance to a semiconductor wet etching solution while suppressing the amount of generation of a sublimate. Another object of the present invention is to provide a method for manufacturing a substrate with a protective film using the protective-film forming composition, a method for manufacturing a substrate with a resist pattern, and a method for manufacturing a semiconductor device.

### Solution to Problem

The inventors of the present invention conducted intensive studies to solve the above-described problems, and as a result, the inventors have found that the above-described problems can be solved by using a protective-film forming composition containing a specific compound, thus completing the present invention.

That is, the present invention includes the following aspects.
[1] A protective-film forming composition against a semiconductor wet etching solution, including:
   component (A): a film-forming component;
   component (B): a compound selected from the group consisting of condensed tannin (b1) obtained by polymerizing a compound having a flavanol skeleton, hydrolyzable tannin (b2) obtained by ester-bonding an aromatic compound of gallic acid or ellagic acid to a sugar, and a flavonoid (b3) derived from a compound having a flavanone skeleton structure; and
   component (C): a solvent.
[2] The protective-film forming composition according to [1], wherein the component (B) is one or more compounds selected from the condensed tannin and the hydrolyzable tannin.
[3] The protective-film forming composition according to [1] or [2], wherein the component (B) is the hydrolyzable tannin.
[4] The protective-film forming composition according to [3], wherein the hydrolyzable tannin is tannic acid represented by the following formula (I): 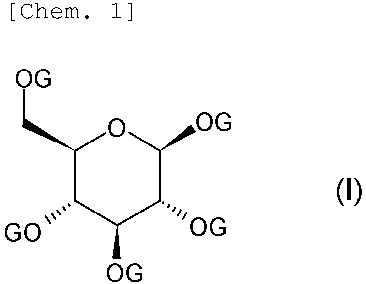
   wherein G each independently represents a hydrogen atom or a monovalent group represented by the following formula (II), 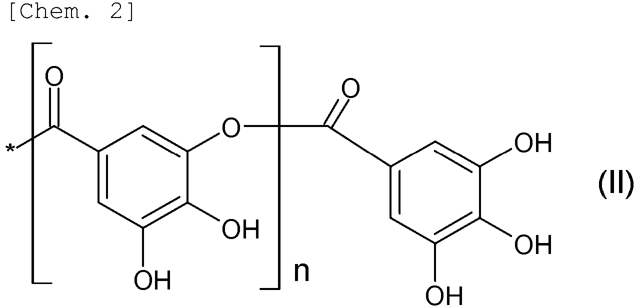
   wherein n represents an integer of 0 to 3, provided that the number of benzene rings in the formula (I) is 4 or more and 17 or less, and * represents a bond.
[5] The protective-film forming composition according to any one of [1] to [4], further including component (D): a curing catalyst.
[6] The protective-film forming composition according to any one of [1] to [5], wherein a content of the component (B) is 0.1 to 50 mass% with respect to the mass of the solid content of the component (A).
[7] A protective film against a semiconductor wet etching solution, wherein the protective film is a baked product of a coating film formed of the protective-film forming composition according to any one of [1] to [6].
[8] A method for manufacturing a substrate with a protective film used in semiconductor manufacturing, the method including a step of applying the protective-film forming composition according to any one of [1] to [6] on a semiconductor substrate and baking the protective-film forming composition to form a protective film.
[9] A method for manufacturing a substrate with a resist pattern used in semiconductor manufacturing, the method including steps of:
   applying the protective-film forming composition according to any one of [1] to [6] on a semiconductor substrate and baking the protective-film forming composition to form a protective film as a resist underlayer film; and
   forming a resist film directly on the protective film or over the protective film, with another layer interlayered, and exposing and developing the resist film to form a resist pattern.
[10] A method for manufacturing a semiconductor device, the method including a step of forming a protective film using the protective-film forming composition according to any one of [1] to [6] on a semiconductor substrate having a surface on which an inorganic film may be formed, forming a resist pattern on the protective film, dry etching the protective film using the resist pattern as a mask to expose the inorganic film or the surface of the semiconductor substrate, and wet etching and cleaning the inorganic film or the semiconductor substrate using a semiconductor wet etching solution using the protective film after the dry etching as a mask.

### Advantageous Effects of Invention

According to the present invention, a protective-film forming composition capable of forming a protective film having excellent resistance to a semiconductor wet etching solution while suppressing the amount of generation of a sublimate, can be provided. Further, according to the present invention, it is also possible to provide a method for manufacturing a substrate with a protective film using the protective-film forming composition, a method for manufacturing a substrate with a resist pattern, and a method for manufacturing a semiconductor device.

### Brief Description of Drawings

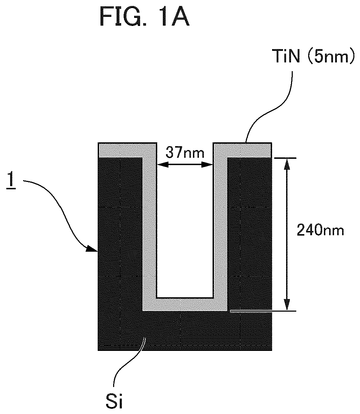

[Fig. 1A] Fig. 1A is a cross-sectional view schematically illustrating a part of a semiconductor substrate used in a resistance test.

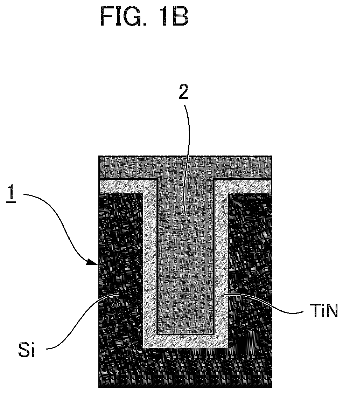

[Fig. 1B] Fig. 1B is a cross-sectional view schematically illustrating a part of a semiconductor substrate on which a protective film is formed.

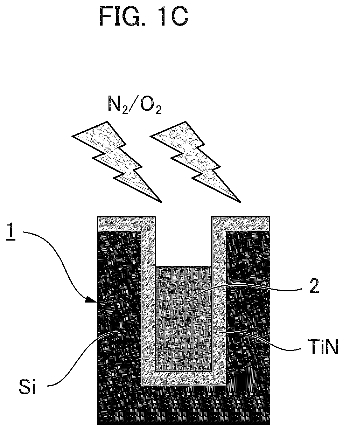

[Fig. 1C] Fig. 1C is a cross-sectional view schematically illustrating a part of a semiconductor substrate after dry etching.

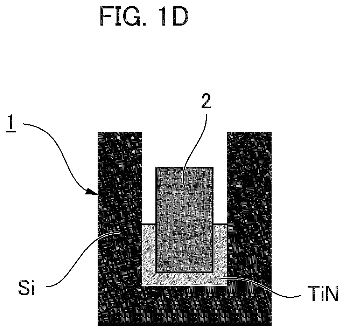

[Fig. 1D] Fig. 1D is a cross-sectional view schematically illustrating a part of a semiconductor substrate after wet etching.

### Description of Embodiments

### (Protective-film forming composition)

A protective-film forming composition of the present invention is a composition for forming a protective film.

The protective film is preferably a protective film that protects an inorganic film formed on a surface of a semiconductor substrate from wet etching.

The protective-film forming composition contains a component (A), a component (B), and a component (C).

The component (A) is a film-forming component.

The component (B) is a compound selected from the group consisting of condensed tannin (b1) obtained by polymerizing a compound having a flavanol skeleton, hydrolyzable tannin (b2) obtained by ester-bonding an aromatic compound of gallic acid or ellagic acid to a sugar, and a flavonoid (b3) derived from a compound having a flavanone skeleton structure.

The component (C) is a solvent.

The present inventors conducted extensive studies for forming a protective film having excellent resistance to a semiconductor wet etching solution. Then, the present inventors found that when an additive having an aromatic ring and an aromatic hydroxy group (for example, gallic acid) is contained in a protective-film forming composition, a protective film having excellent resistance to a semiconductor wet etching solution can be formed.

However, the present inventors found that when the additive is contained in a protective-film forming composition, the amount of a sublimate generated from the protective film increases.

Thus, as a result of conducting further studies, the present inventors found that a protective film having excellent resistance to a semiconductor wet etching solution while suppressing the amount of generation of a sublimate can be formed, not by allowing a protective-film forming composition to simply contain an additive having an aromatic ring and an aromatic hydroxy group, but by allowing the protective-film forming composition to contain a specific component (B), thus completing the present invention.

### <Component (A)>

The component (A) is a film-forming component. In the present description, the film-forming component refers to a component other than the component (B) and the component (C) in the protective-film forming composition.

The film-forming component includes, for example, an organic compound. The organic compound may be a low molecular compound or a high-molecular-weight compound (polymer).

Examples of such an organic compound include the following compounds.
· A compound having a group represented by Formula (1) in the protective-film forming composition described in WO 2017/191767 A at a side chain or a terminal and having a weight average molecular weight of 800 or more
· A compound represented by Formula (1a) or Formula (1b), a compound having a substituent represented by Formula (2) and having a molecular weight of 300 or more and less than 800, or a compound having a weight average molecular weight of 300 or more and less than 800 in the protective-film forming composition described in WO 2018/052130 A
· A resin in the protective-film forming composition described in WO 2018/203464 A (for example, polyester, polyether, polyether ether ketone, novolac resin, maleimide resin, acrylic resin, and methacrylic resin)
· A compound containing at least one set of two hydroxyl groups adjacent to each other in the molecule in the protective-film forming composition described in WO 2019/124474 A, or a polymer thereof
· A compound containing at least one acetal structure in the molecule in the protective-film forming composition described in WO 2019/124475 A, or a polymer thereof
· A ring-opening polymer (C) obtained by reaction of a diepoxy compound (A) with a di- or higher functional proton generating compound (B) in the protective-film forming composition described in WO 2020/090950 A
· A compound or polymer containing at least one acetal structure and at least one amide structure in the protective-film forming composition described in WO 2020/153278 A

The contents of these publications are incorporated herein by reference to the same extent as if fully set forth.

The polymer is not particularly limited, but preferably contains a polymer having at least one of a partial structure represented by the following formula (1), a partial structure represented by the following formula (2), and a partial structure represented by the following formula (3) (hereinafter, it may be referred to as a "polymer (A)").

The polymer (A) preferably has a partial structure represented by the following formula (1), a partial structure represented by the following formula (2), and a partial structure represented by the following formula (3).

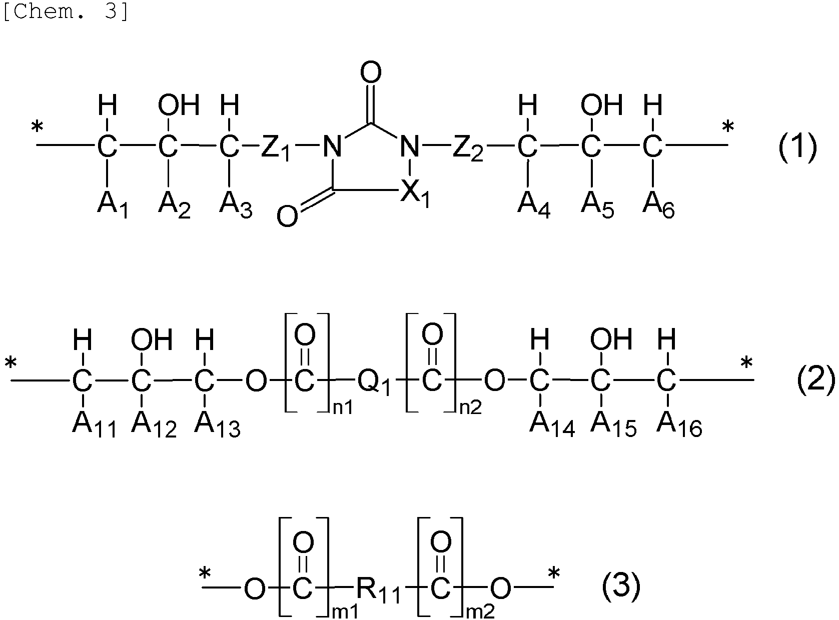

In the formula (1), X₁ represents a divalent group represented by the following formula (1-1); the following formula (1-2), or the following formula (1-3); Z₁ and Z₂ each independently represent a direct bond or a divalent group represented by the following formula (1-4); A₁, A₂, A₃, A₄, A₅, and A₆ each independently represent a hydrogen atom, a methyl group or an ethyl group; and * represents a bond.

In the formula (2), Q₁ represents a divalent organic group having an aromatic hydrocarbon ring or an aliphatic hydrocarbon ring; A₁₁, A₁₂, A₁₃, A₁₄, A₁₅, and A₁₆ each independently represent a hydrogen atom, a methyl group, or an ethyl group; n1 and n2 each independently represent 0 or 1; and * represents a bond.

In the formula (3), R₁₁ represents an organic group having 1 to 30 carbon atoms; m1 and m2 each independently represent 0 or 1; and * represents a bond.

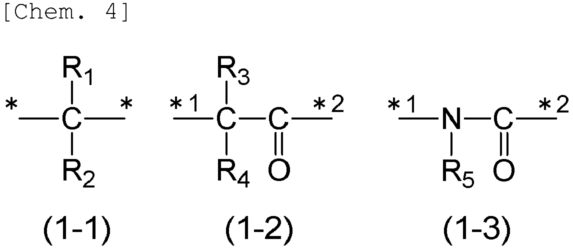

In the formulae (1-1) to (1-3), R₁ to R₅ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group or a phenyl group, and the phenyl group may be substituted by at least one monovalent group selected from the group consisting of an alkyl group having 1 to 6 carbon atoms, a halogen atom, an alkoxy group having 1 to 6 carbon atoms, a nitro group, a cyano group and an alkylthio group having 1 to 6 carbon atoms; R₁ and R₂ may be bonded to each other to form a ring having 3 to 6 carbon atoms; R₃ and R₄ may be bonded to each other to form a ring having 3 to 6 carbon atoms; * represents a bond; *1 represents a bond bonded to a carbon atom; and *2 represents a bond bonded to a nitrogen atom.

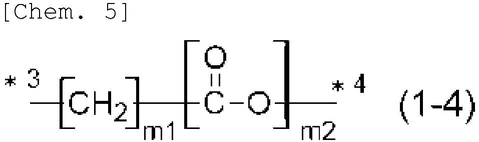

In the formula (1-4), m1 is an integer of 1 to 4; m2 is 0 or 1; *3 represents a bond bonded to a nitrogen atom; and *4 represents a bond bonded to a carbon atom.

Examples of the alkyl group having 1 to 10 carbon atoms which may be interrupted by an oxygen atom or a sulfur atom in R₁ to R₅ in the formulae (1-1) to (1-3) include an alkyl group having 1 to 10 carbon atoms, an alkoxy group having 1 to 10 carbon atoms, an alkoxyalkyl group having 2 to 10 carbon atoms, an alkoxyalkoxyalkyl group having 3 to 10 carbon atoms, an alkylthio group having 1 to 10 carbon atoms, and an alkylthioalkyl group having 2 to 10 carbon atoms.

The alkyl group having 1 to 10 carbon atoms which may be interrupted by an oxygen atom or a sulfur atom may contain two or more oxygen atoms or sulfur atoms.

### <<X₁>>

X₁ in the formula (1) is preferably represented by the formula (1-3) from the viewpoint of suitably obtaining the effect of the present invention.

Examples of the structure represented by the following (1A) in the formula (1) include: 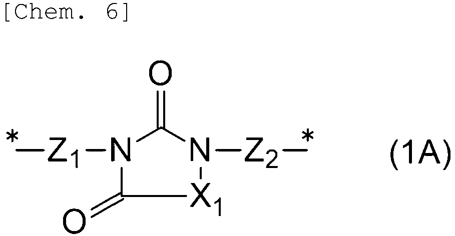 (In the formula (1A), Z₁, Z₂ and X₁ are the same as Z₁, Z₂ and X₁ in the formula (1), respectively; and * represents a bond.) Examples thereof include structures exemplified below.

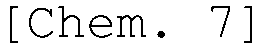

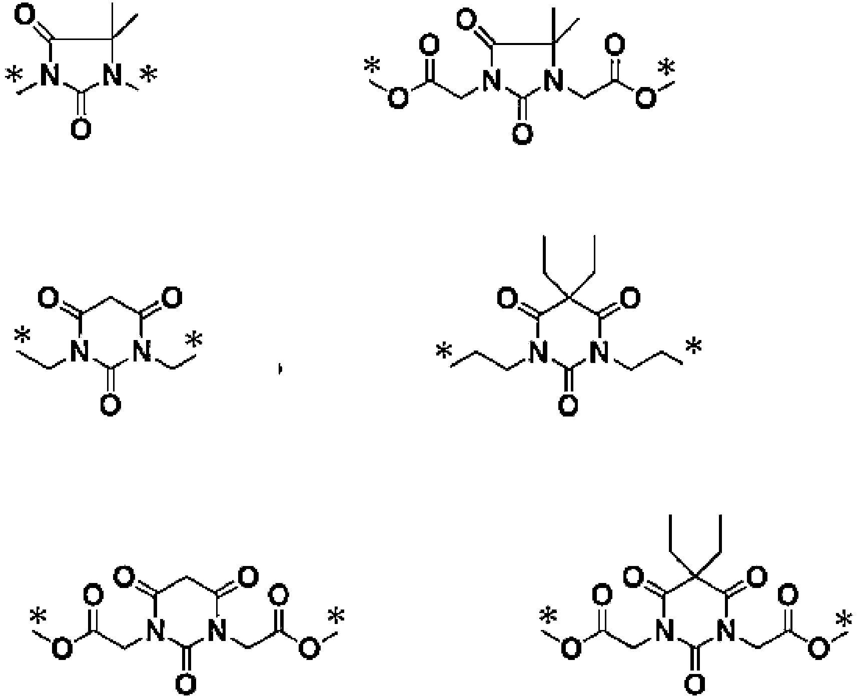

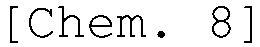

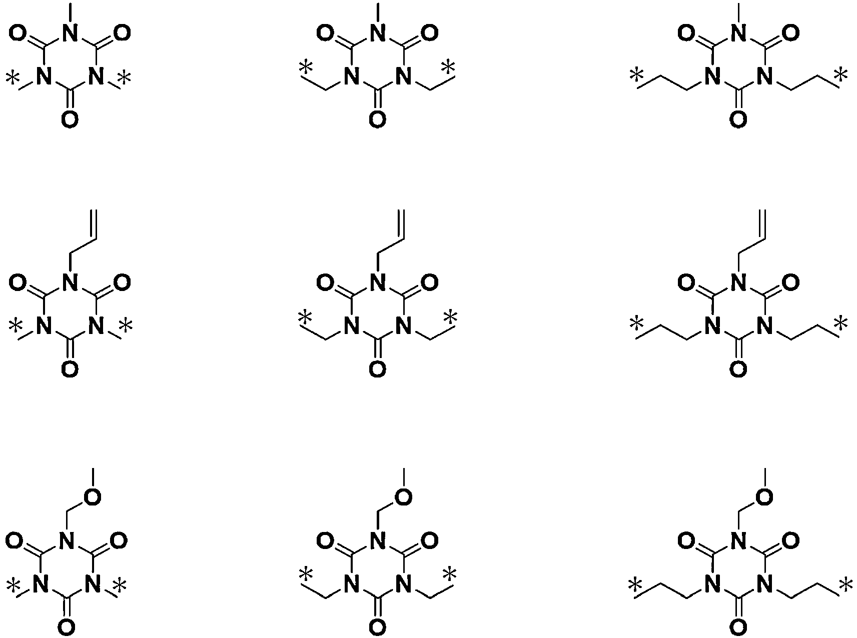

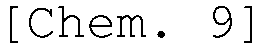

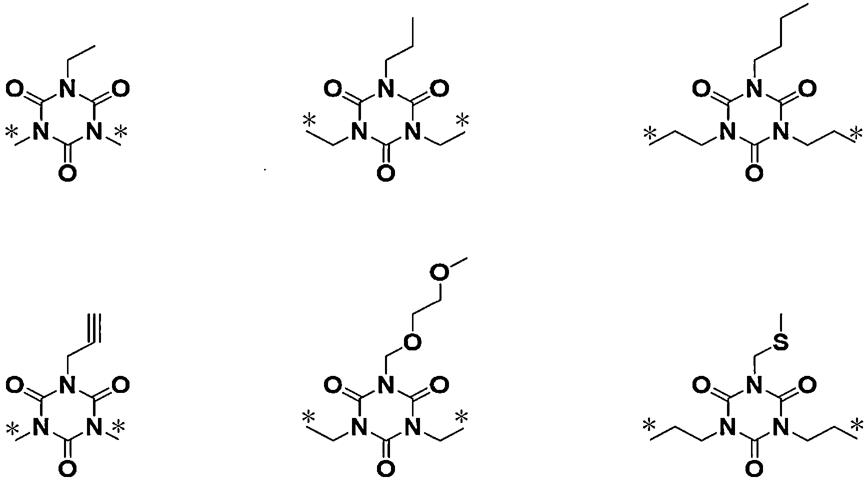

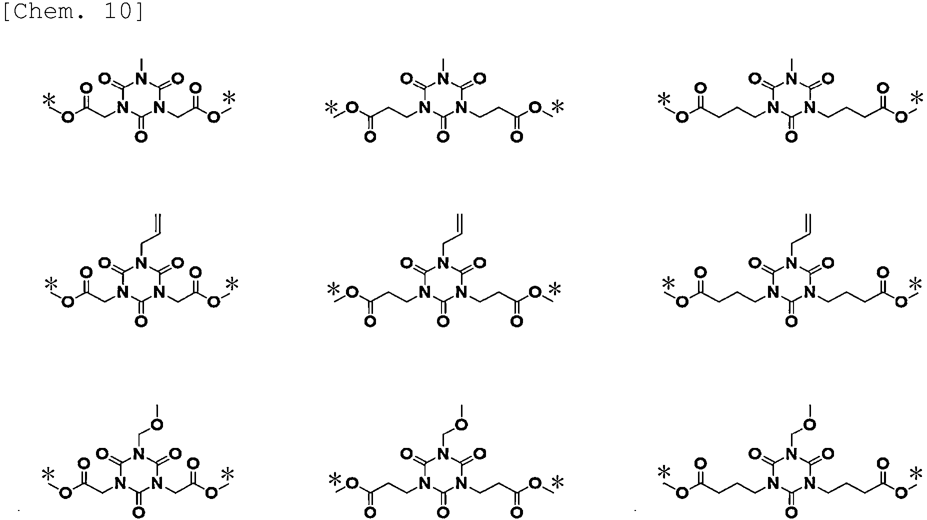

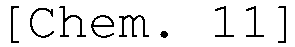

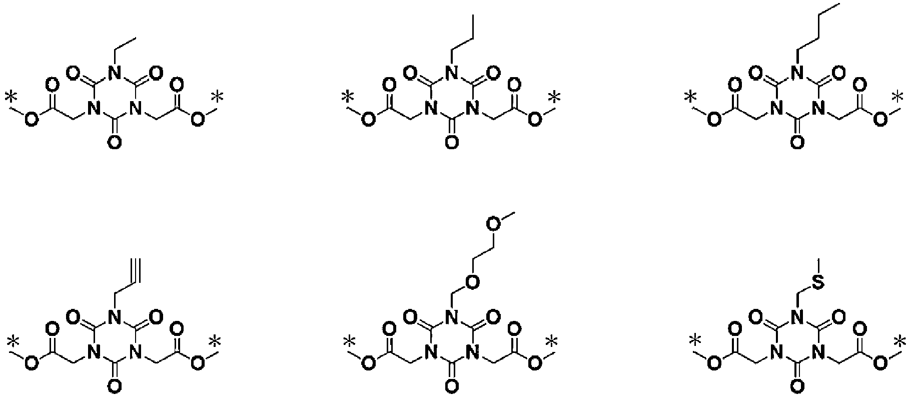

In the above structures, * represents a bond.

### <<Q₁>>

Q₁ in the formula (2) is preferably represented by any one of the following formulae (2-1) to (2-4) from the viewpoint of suitably obtaining the effect of the present invention.

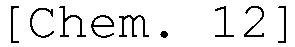

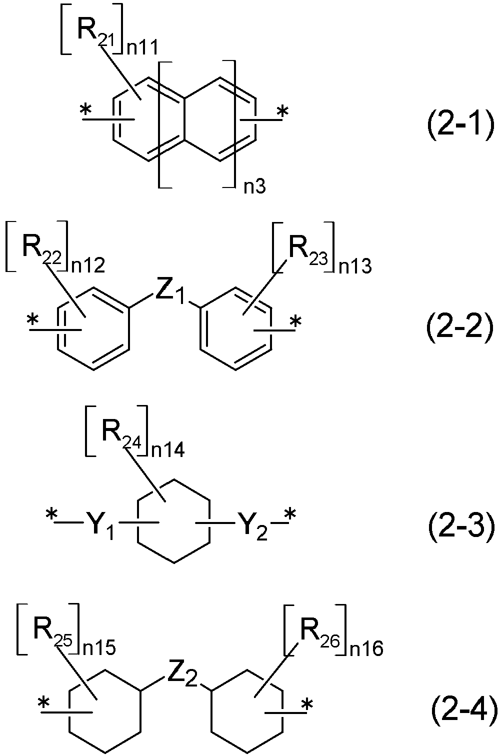

In the formulae (2-1) to (2-4), R₂₁ to R₂₆ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms, or an aralkyl group having 7 to 13 carbon atoms, and * represents a bond.

In the formula (2-1), n3 represents 0 or 1, when n3 is 0, n11 represents an integer of 0 to 4, when n3 is 1, n11 represents an integer of 0 to 6, and when there are two or more R₂₁'s, the two or more R₂₁'s may be the same or different.

In the formula (2-2), Z₁ represents a single bond, an oxygen atom, a sulfur atom, a carbonyl group, a sulfonyl group, or an alkylene group having 1 to 6 carbon atoms, n12 and n13 each independently represent an integer of 0 to 4, when there are two or more R₂₂'s, the two or more R₂₂'s may be the same or different, and when there are two or more R₂₃'s, the two or more R₂₃'s may be the same or different.

In the formula (2-3), Y₁ and Y₂ each independently represent a single bond or an alkylene group having 1 to 6 carbon atoms, n14 represents an integer of 0 to 4, and when there are two or more R₂₄'s, the two or more R₂₄'s may be the same or different.

In the formula (2-4), Z₂ represents a single bond, an oxygen atom, a sulfur atom, a carbonyl group, a sulfonyl group, or an alkylene group having 1 to 6 carbon atoms, n15 and n16 each independently represent an integer of 0 to 4, when there are two or more R₂₅'s, the two or more R₂₅'s may be the same or different, and when there are two or more R₂₆'s, the two or more R₂₆'s may be the same or different.

In the present description, examples of the halogen atom include a fluorine atom, a chlorine atom, a bromine atom, and an iodine atom.

In the present description, the alkyl group is not limited to a linear alkyl group, and may be branched or cyclic. Examples of the linear or branched alkyl group include a methyl group, an ethyl group, an isopropyl group, a tert-butyl group, and an n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, a n-pentyloxy group, and an isopropoxy group.

In the present description, examples of the alkylthio group include a methylthio group, an ethylthio group, a n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include a group in which a double bond of an alkenyl group listed above as the "alkenyl group" is replaced with a triple bond.

In the present description, examples of the alkenyloxy group include a vinyloxy group, a 1-propenyloxy group, a 2-n-propenyloxy group (allyloxy group), a 1-n-butenyloxy group, and a prenyloxy group.

In the present description, examples of the alkynyloxy group include a 2-propynyloxy group, a 1-methyl-2-propynyloxy group, a 2-methyl-2-propynyloxy group, a 2-butynyloxy group, and a 3-butynyloxy group.

In the present description, examples of the acyl group include an acetyl group and a propionyl group.

In the present description, examples of the aryloxy group include a phenoxy group and naphthyloxy.

In the present description, examples of the arylcarbonyl group include a phenylcarbonyl group.

In the present description, examples of the aralkyl group include a benzyl group and a phenethyl group.

In the present description, examples of the alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the structure represented by the following (2A) in the formula (2) include: 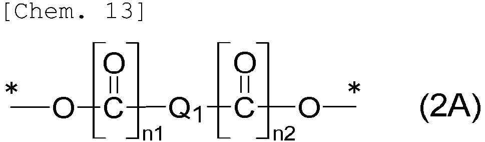 (In the formula (2A), Q₁, n1, and n2 are the same as Q₁, n1, and n2 in the formula (2), respectively. * represents a bond.) Examples thereof include structures exemplified below.

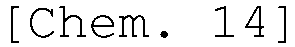

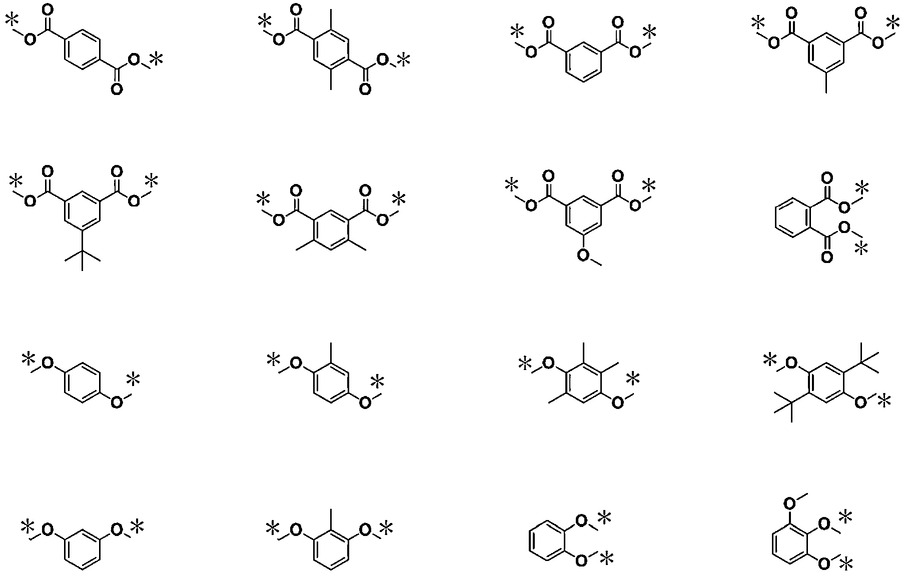

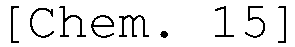

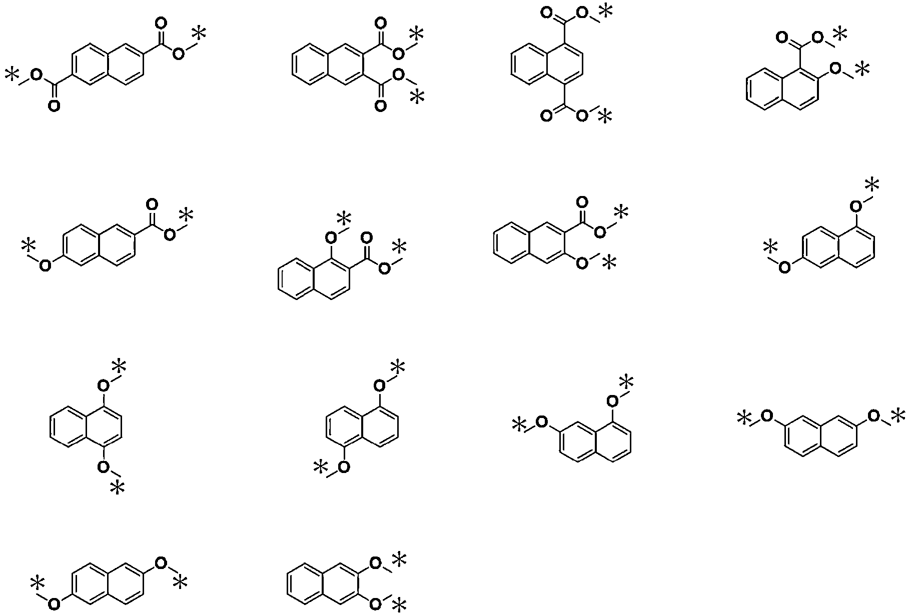

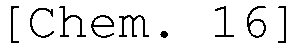

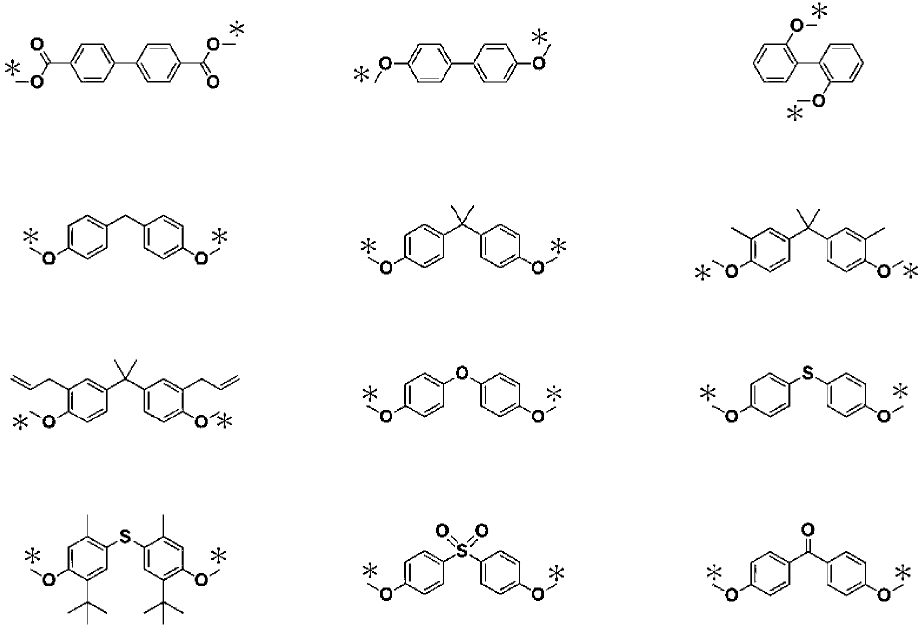

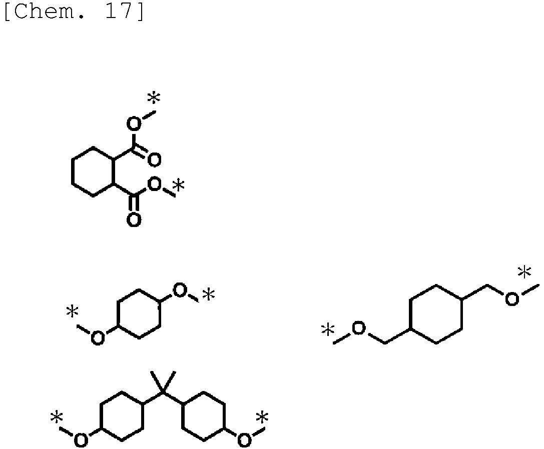

In the above structures, * represents a bond.

The organic group having 1 to 30 carbon atoms of R₁₁ in the formula (3) may have, for example, an aromatic ring or may not have an aromatic ring. Examples of the aromatic ring include an aromatic hydrocarbon ring and an aromatic heterocyclic ring.

The organic group having 1 to 30 carbon atoms of R₁₁ in the formula (3) may have, for example, an aliphatic ring or may not have an aliphatic ring.

The organic group having 1 to 30 carbon atoms of R₁₁ in the formula (3) may have, for example, an unsaturated bond or may not have an unsaturated bond.

Examples of the organic group having 1 to 30 carbon atoms of R₁₁ in the formula (3) include an alkylene group having 1 to 10 carbon atoms, which may be interrupted by an oxygen atom or a sulfur atom. The alkylene group having 1 to 10 carbon atoms which may be interrupted by an oxygen atom or a sulfur atom may contain two or more oxygen atoms or sulfur atoms.

Examples of the partial structure represented by the formula (3) include the following structures.

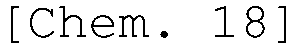

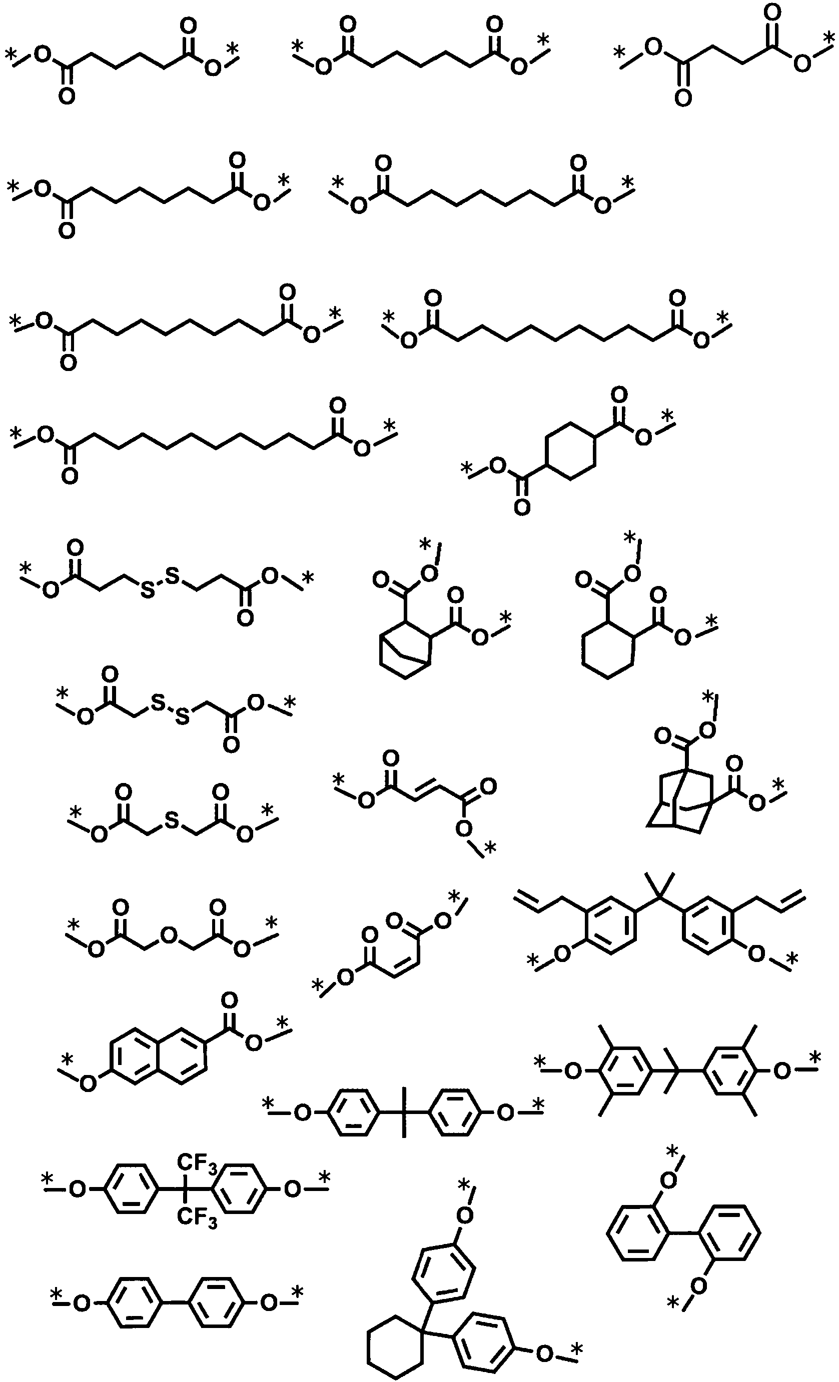

In the formula, * represents a bond.

From the viewpoint of suitably obtaining the effect of the present invention, the polymer (A) preferably has at least one of a repeating unit represented by the following formula (A) and a repeating unit represented by the following formula (B).

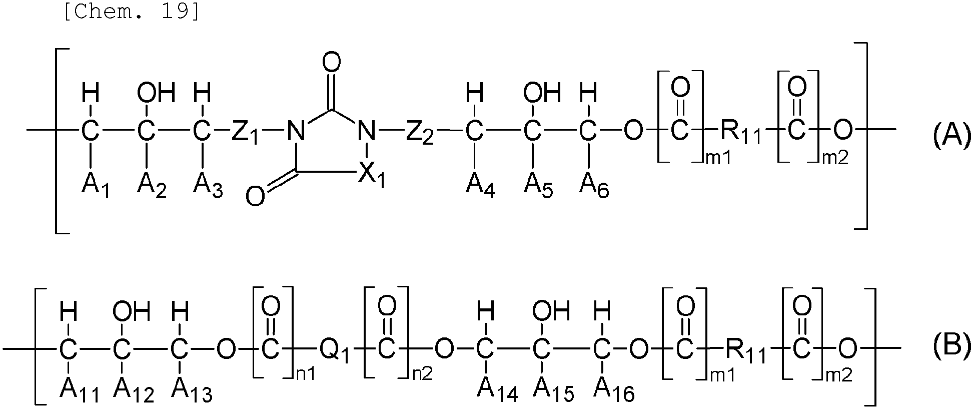

In the formula (A), X₁, Z₁, Z₂, A₁, A₂, A₃, A₄, A₅, and A₆ are the same as X₁, Z₁, Z₂, A₁, A₂, A₃, A₄, A₅, and As in the formula (1), respectively, R₁₁, m1, and m2 are the same as R₁₁, m1, and m2 in the formula (3), respectively,
in the formula (B), Q₁, A₁₁, A₁₂, A₁₃, A₁₄, A₁₅, A₁₆, n1, and n2 are the same as Q₁, A₁₁, A₁₂. A₁₃, A₁₄, A₁₅, A₁₆, n1, and n2 in the formula (2), respectively, and R₁₁, m1, and m2 are the same as R₁₁, m1, and m2 in the formula (3), respectively.

The molar ratio (M1 : M2) between the partial structure (M1) represented by the formula (1) and the partial structure (M2) represented by the formula (2) in the polymer (A) is not particularly limited, but is preferably 95 : 5 to 10 : 90, more preferably 95 : 5 to 20 : 80, and particularly preferably 95 : 5 to 40 : 60.

The molar ratio [(M1 + M2) : M3] of the sum of the partial structure (M1) represented by the formula (1) and the partial structure (M2) represented by the formula (2) to the partial structure represented by the formula (3) in the polymer (A) is not particularly limited, but is preferably 80 : 20 to 20 : 80, more preferably 70 : 30 to 30 : 70, and particularly preferably 60 : 40 to 40 : 60.

The molar ratio (MA : MB) between the repeating unit (MA) represented by the formula (A) and the repeating unit (MB) represented by the formula (B) in the polymer (A) is not particularly limited, but is preferably 95 : 5 to 10 : 90, more preferably 95 : 5 to 20 : 80, and particularly preferably 95 : 5 to 40 : 60.

The molar ratio of the sum of the repeating unit (MA) represented by the formula (A) and the repeating unit (MB) represented by the formula (B) to all the repeating units of the polymer (A) is not particularly limited, but is preferably 70 mol% or more, more preferably 80 mol% or more, and particularly preferably 90 mol% or more. The upper limit is not particularly limited, but is preferably 100 mol% or less.

Examples of the polymer (A) include the following polymers (1a) to (1o).

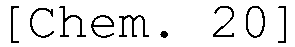

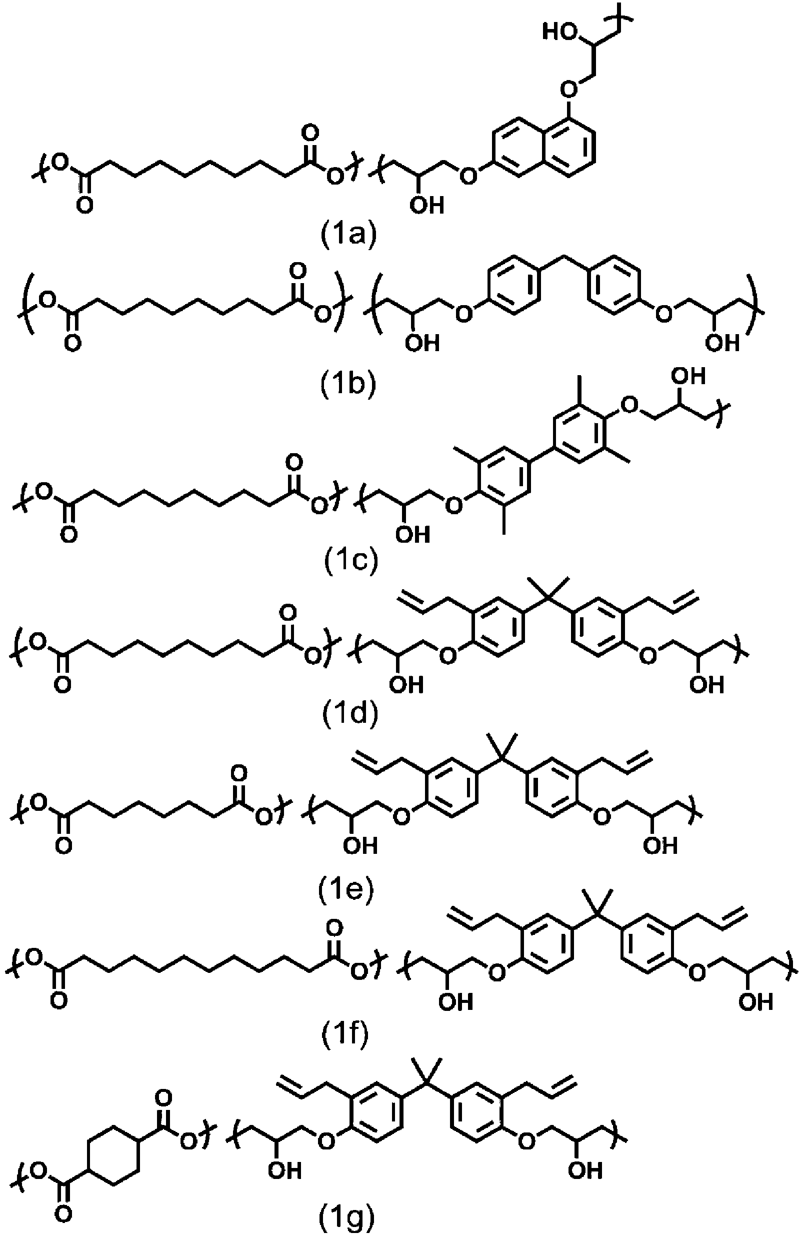

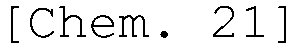

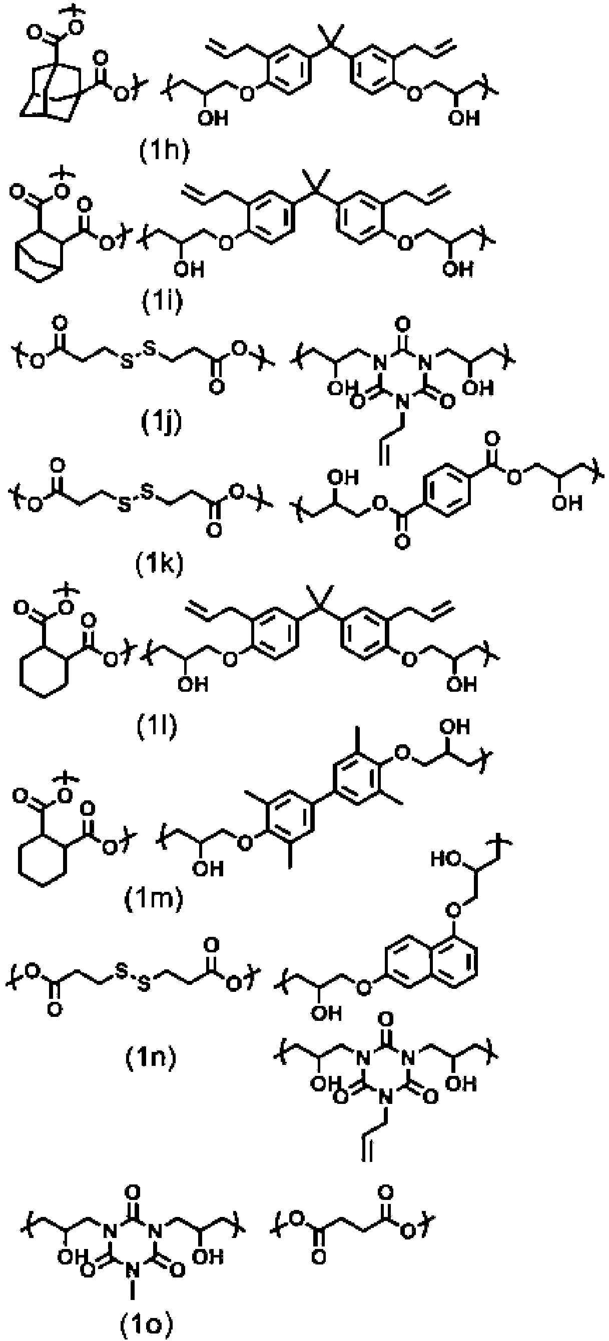

### <<Method for manufacturing polymer>>

An example of the method for manufacturing the polymer (A) is not particularly limited, and examples thereof include a method of reacting at least one of a diepoxy compound represented by the following formula (A1) and a diepoxy compound represented by the following formula (A2), and a dicarboxylic acid, a monocarboxylic acid, or a diol represented by the following formula (A3).

For example, at least one of a diepoxy compound represented by the following formula (A1) and a diepoxy compound represented by the following formula (A2), and a dicarboxylic acid, a monocarboxylic acid, or a diol represented by the following formula (A3) are dissolved in an organic solvent at an appropriate molar ratio. A polymer is obtained by polymerization in the presence of a catalyst that activates an epoxy group.

When the polymer (A) is manufactured, a diepoxy compound other than the diepoxy compound represented by the formula (A1) and the diepoxy compound represented by the formula (A2) may be used in combination. Also, when the polymer is manufactured, a dicarboxylic acid, a monocarboxylic acid, or a diol other than the dicarboxylic acid, the monocarboxylic acid, or the diol represented by the formula (A3) may be used in combination.

Examples of the catalyst for activating an epoxy group include a quaternary phosphonium salt such as tetrabutylphosphonium bromide or ethyltriphenylphosphonium bromide, and a quaternary ammonium salt such as benzyltriethylammonium chloride. As the amount of the catalyst used, an appropriate amount can be selected and used from the range of 0.1 to 10 mass% with respect to the total mass of the polymer raw material used in the reaction. As the temperature and the time for the polymerization reaction, for example, optimum conditions can be selected from the ranges of 80 to 160°C and 2 to 50 hours.

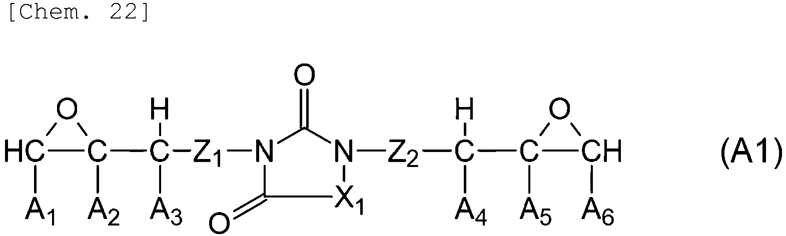

In the formula (A1), X₁, Z₁, Z₂, A₁, A₂, A₃, A₄, A₅, and A₆ are the same as X₁, Z₁, Z₂, A₁, A₂, A₃, A₄, A₅, and A₆ in the formula (1), respectively.

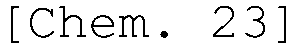

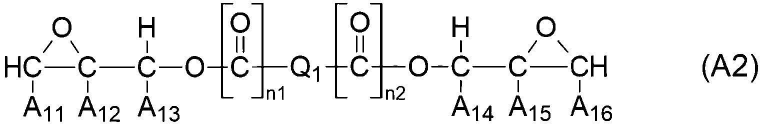

In the formula (A2), Q₁, A₁₁, A₁₂, A₁₃, A₁₄, A₁₅, A₁₆, n1, and n2 are the same as Q₁, A₁₁, A₁₂, A₁₃, A₁₄, A₁₅, A₁₆, n1, and n2 in the formula (2), respectively.

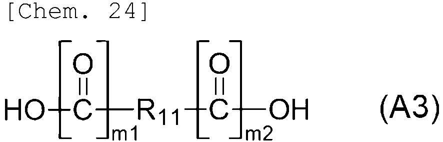

In the formula (A3), R₁₁, m1, and m2 are the same as R₁₁, m1, and m2 in the formula (3), respectively.

Examples of the diepoxy compound represented by the formula (A1) include the following diepoxy compounds.

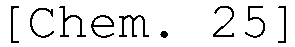

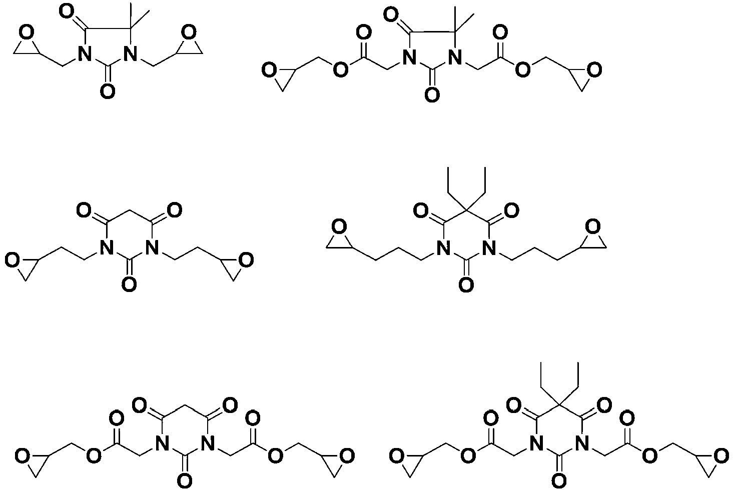

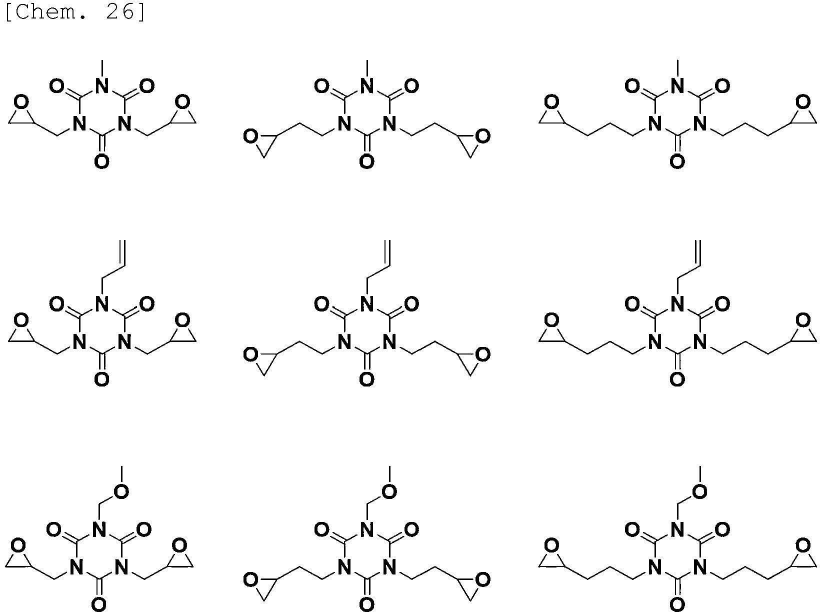

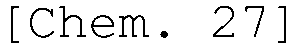

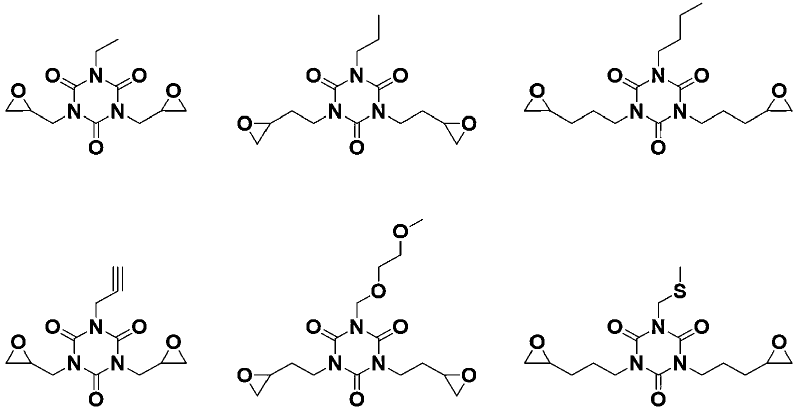

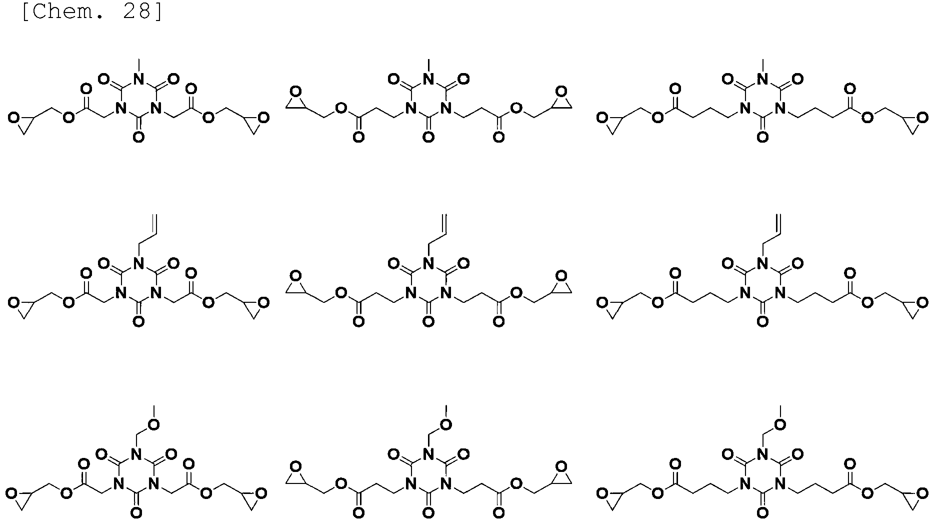

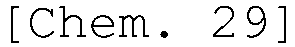

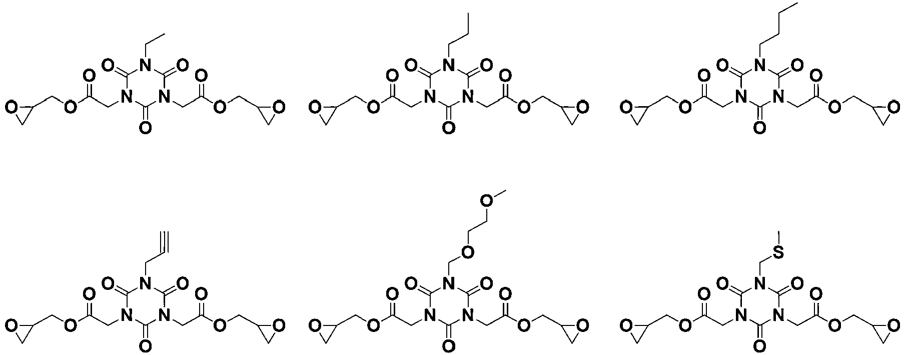

Examples of the diepoxy compound represented by the formula (A2) include the following diepoxy compounds.

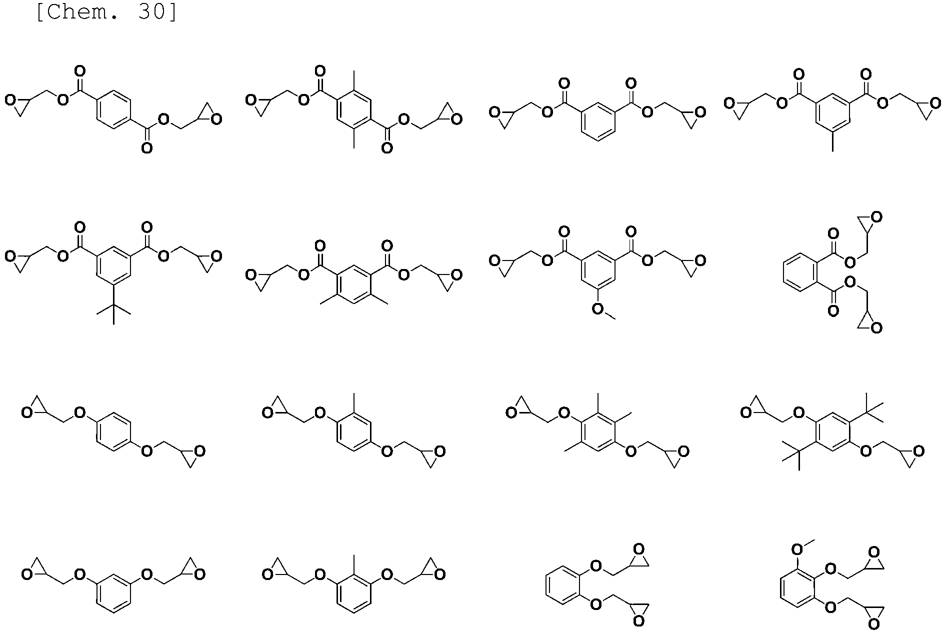

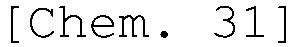

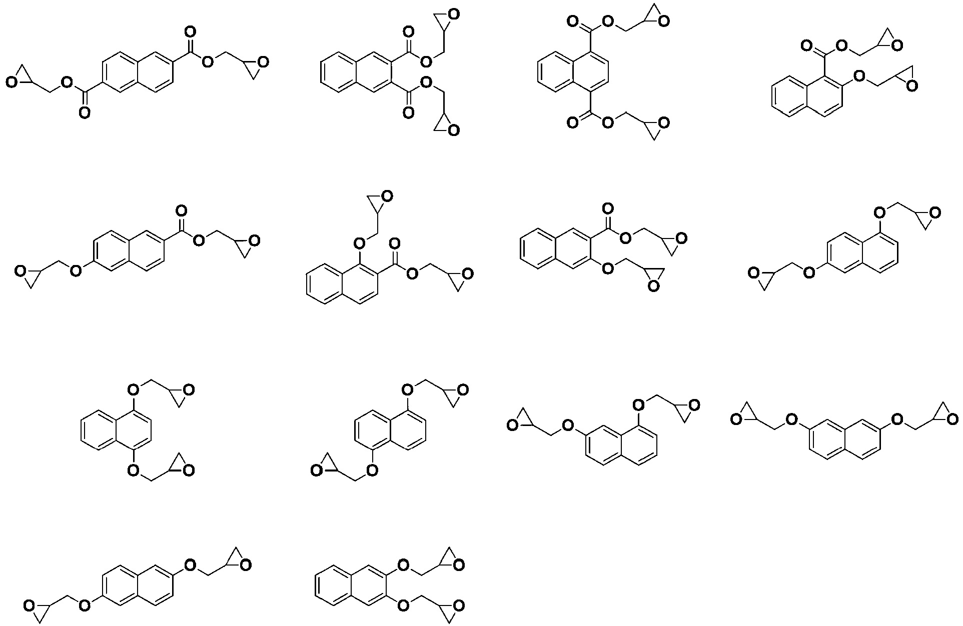

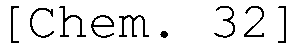

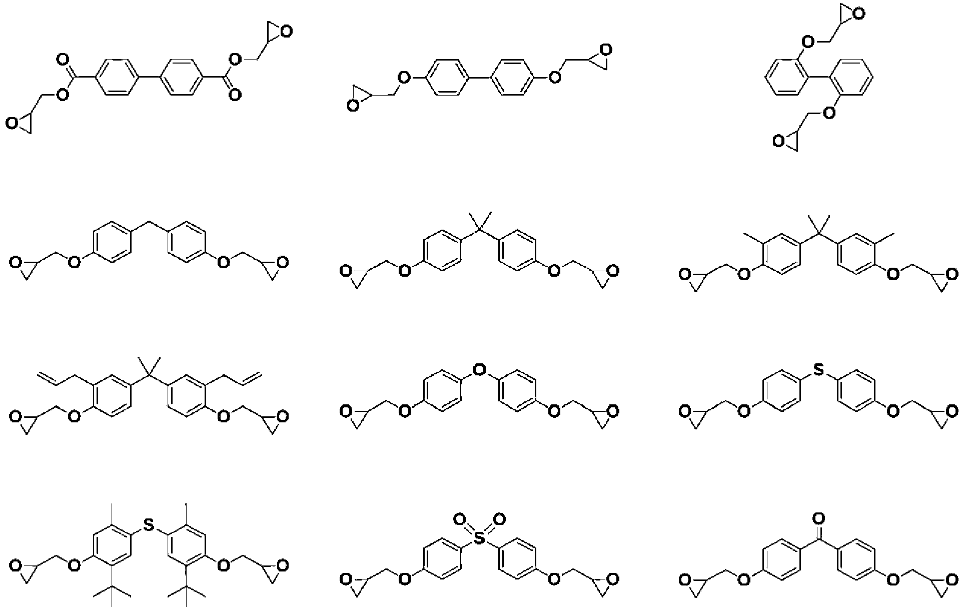

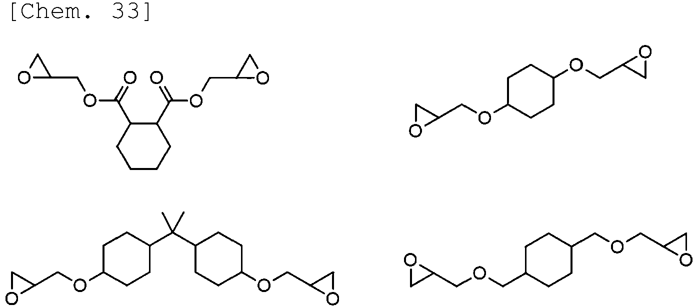

Examples of the dicarboxylic acid, the monocarboxylic acid, or the diol represented by the formula (A3) include the following compounds.

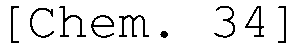

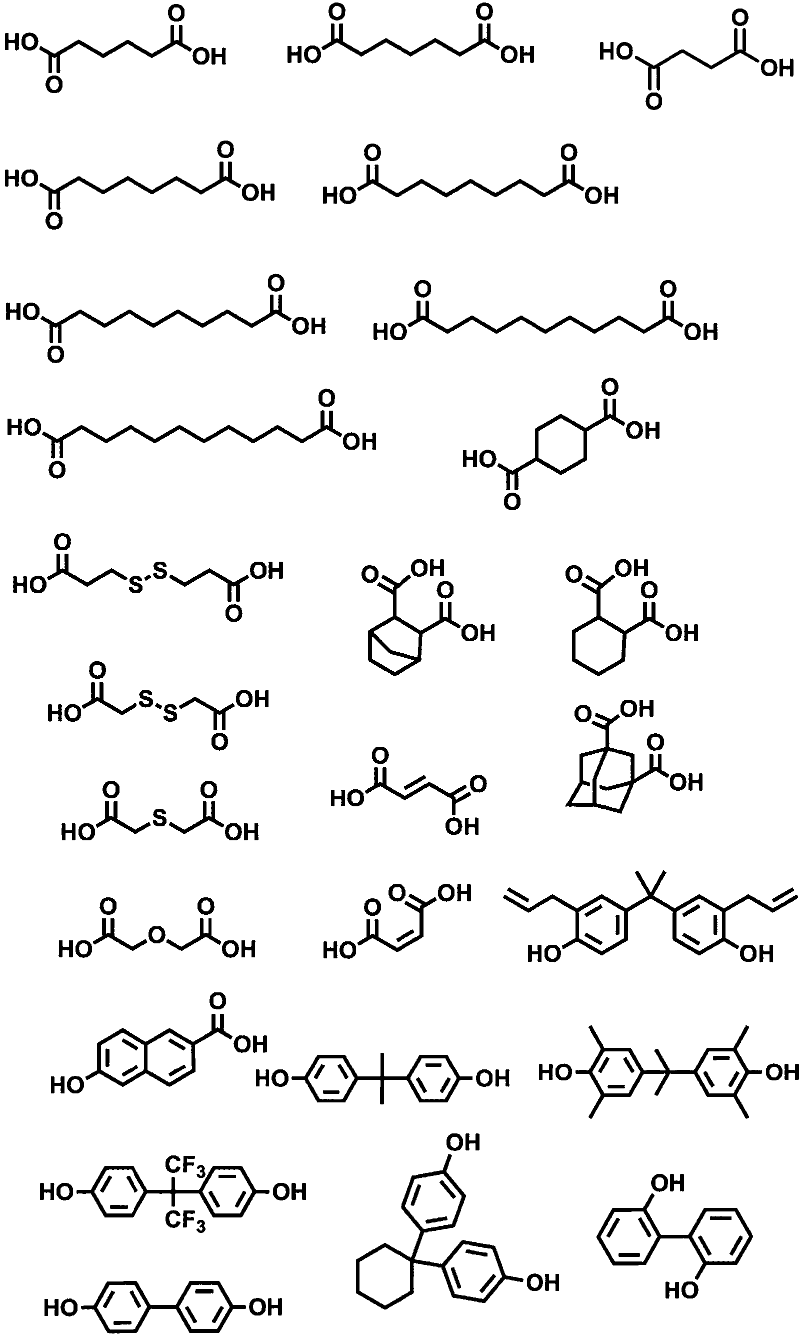

As the polymer, in addition to the polymer (A) described above, an acrylic resin, an epoxy resin, a novolac resin, and the like can also be used.

The weight average molecular weight Mw of the polymer (for example, the polymer (A)) is not particularly limited, but is preferably 1,000 to 50,000, more preferably 1,500 to 30,000, and particularly preferably 2,000 to 10,000.

In the present invention, the weight average molecular weight Mw is a value in terms of polystyrene measured by gel permeation chromatography (GPC).

The content of the polymer (for example, the polymer (A)) in the protective-film forming composition is not particularly limited, and is preferably 50 mass% to 100 mass%, more preferably 75 mass% to 100 mass%, and particularly preferably 90 mass% to 100 mass% based on the film-forming component.

### <Component (B)>

The component (B) is a compound selected from the group consisting of condensed tannin (b1) obtained by polymerizing a compound having a flavanol skeleton, hydrolyzable tannin (b2) obtained by ester-bonding an aromatic compound of gallic acid or ellagic acid to a sugar, and a flavonoid (b3) derived from a compound having a flavanone skeleton structure.

### <<(b1)>>

(b1) is a condensed tannin obtained by polymerizing a compound having a flavanol skeleton.

In the present description, the "tannin" refers to a water-soluble compound that is derived from a plant, reacts with and strongly binds to a protein, an alkaloid, or a metal ion to form a poorly soluble salt. A tannin is an aromatic compound which is ubiquitous in the plant kingdom and has many phenolic hydroxy groups.

The tannin according to the present embodiment includes a condensed tannin and a hydrolyzable tannin.

The condensed tannin according to the present embodiment is a compound obtained by polymerizing a compound having a flavanol skeleton represented by the following formula (p).

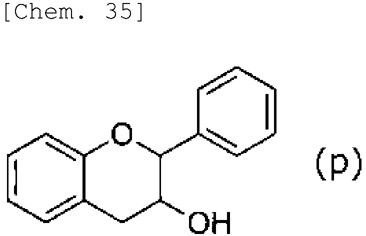

### << (b2) >>

(b2) is a hydrolyzable tannin obtained by ester-bonding an aromatic compound of gallic acid or ellagic acid to a sugar.

The hydrolyzable tannin according to the present embodiment is a compound obtained by ester-bonding an aromatic compound of gallic acid or ellagic acid represented by the following formula (q) to a sugar such as glucose represented by the following formula (r).

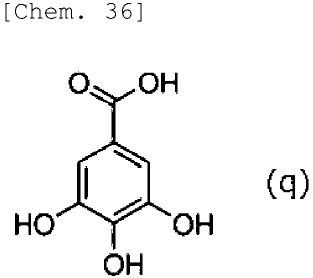

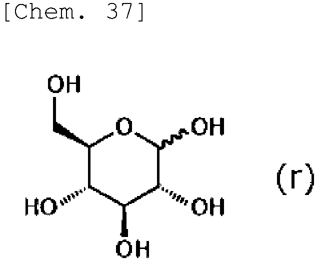

Examples of preferred embodiments of the hydrolyzable tannin include a tannic acid represented by the following formula (I). 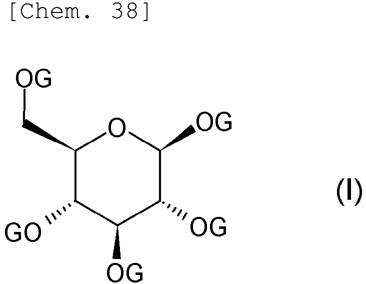
wherein G each independently represents a hydrogen atom or a monovalent group represented by the following formula (II), 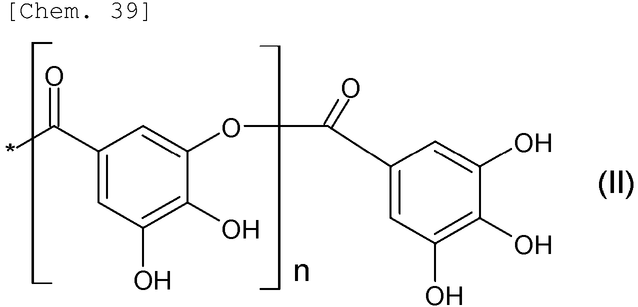
wherein n represents an integer of 0 to 3, provided that the number of benzene rings in the formula (I) is 4 or more and 17 or less, and * represents a bond.

In the formula (II), n is preferably 0 to 2 and more preferably 1 to 2 from the viewpoint of suitably obtaining the effect of the present invention.

An example of the structure of the tannic acid represented by the formula (I) is shown in the following formula (III).

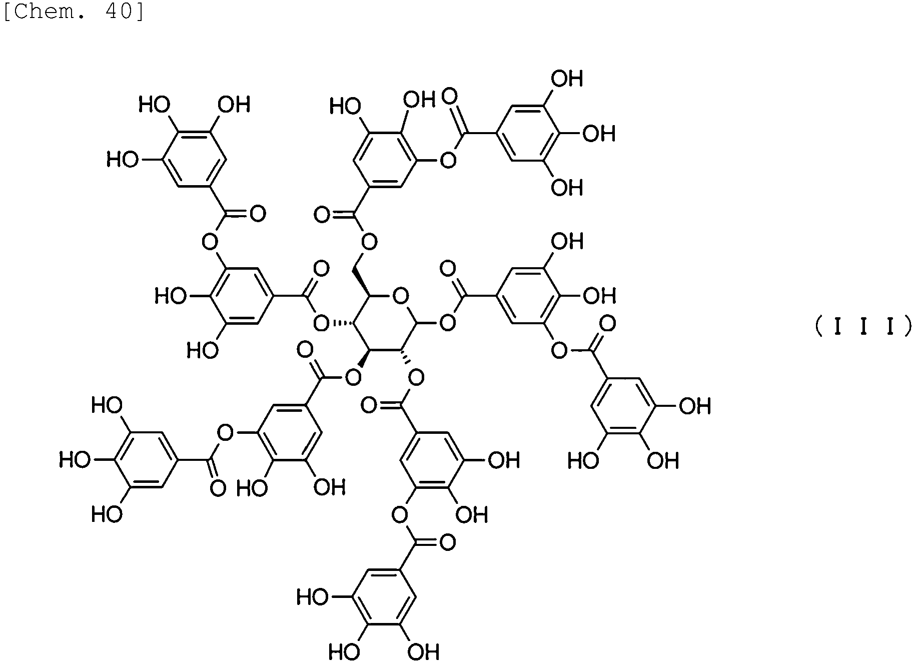

The formula (III) is a compound in which all of G in the formula (I) are monovalent groups represented by the formula (II) and all of n in the formula (II) are 1.

### <<(b3)>>

(b3) is a flavonoid derived from a compound having a flavanone skeleton structure.

The flavonoid according to the present embodiment represents a compound biosynthesized by various modifications of flavanone, which is a type of flavonoid.

Examples of the flavonoid according to the present embodiment include a compound derived from a compound having a flavanone skeleton structure represented by the following formula (s).

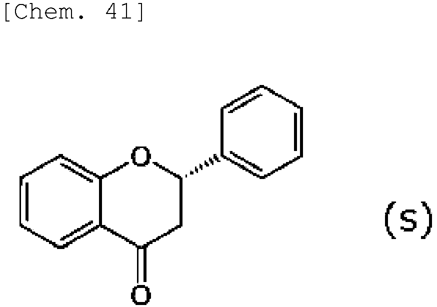

Examples of preferred embodiments of the flavonoid include flavonoids represented by the following formula (s1) or (s2).

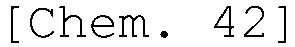

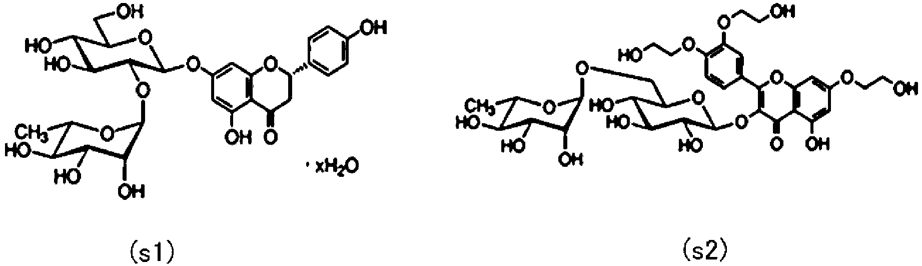

From the viewpoint of suitably obtaining the effect of the present invention, the component (B) is preferably (b2), and more preferably tannic acid represented by the formula (I).

From the viewpoint of suitably obtaining the effect of the present invention, the content of the component (B) is, for example, preferably 0.1 to 50 mass%, more preferably 1 to 20 mass%, and still more preferably 5 to 15 mass% with respect to the component (A).

The weight average molecular weight Mw of the component (B) is not particularly limited, but is, for example, preferably 700 to 2500, more preferably 1000 to 2000, and still more preferably 1500 to 1900.

In the present invention, the weight average molecular weight Mw is a value in terms of polystyrene measured by gel permeation chromatography (GPC).

### <Component (C)>

The component (C) is a solvent.

The protective-film forming composition of the present invention can be prepared by dissolving the respective components described above in a solvent, preferably in an organic solvent, and is used in a uniform solution state.

The organic solvent of the protective-film forming composition according to the present invention can be used without particular limitation as long as it is an organic solvent capable of dissolving solid components such as the component (A), the component (B), and other optional solid components. In particular, since the protective-film forming composition according to the present invention is used in a uniform solution state, it is recommended to use an organic solvent generally used in a lithography process in combination in consideration of application performance thereof.

Examples of the organic solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monoethyl ether, propylene glycol monomethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, 2-heptanone, methoxycyclopentane, anisole, γ-butyrolactone, N-methylpyrrolidone, N,N-dimethylformamide, and N,N-dimethylacetamide. One of these solvents can be used alone, or two or more of these solvents can be used in combination.

Among these solvents, propylene glycol monomethyl ether, propylene glycol monomethyl ether acetate, cyclohexanone, and the like are preferable. In particular, propylene glycol monomethyl ether and propylene glycol monomethyl ether acetate are preferable.

A solid content of the protective-film forming composition according to the present invention is usually 0.1 to 70 mass%, and preferably 0.1 to 60 mass%. The solid content is the content ratio of all components excluding the solvent from the protective-film forming composition. The proportion of the component (A) in the solid content is preferably 1 to 99.9 mass%, more preferably 50 to 99.9 mass%, still more preferably 50 to 95 mass%, and particularly preferably 50 to 90 mass%.

### <Component (D)>

The component (D) is a curing catalyst.

As the curing catalyst contained as an optional component in the protective-film forming composition, both a thermal acid generator and a photoacid generator can be used, but it is preferable to use a thermal acid generator.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photoacid generating agent include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compound include N-(trifluoromethanesulfonyloxy)succinimide, N-(nonafluoro-normal-butanesulfonyloxy)succinimide, N-(camphorsulfonyloxy)succinimide, and N-(trifluoromethanesulfonyloxy)naphthalimide, and the like.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane, and the like.

Only one type of curing catalyst can be used, or two or more types thereof can be used in combination.

In the case of using the curing catalyst, the content ratio of the curing catalyst is, for example, 0.1 mass% to 50 mass%, and preferably 1 mass% to 30 mass% with respect to the component (A).

(Protective Film, Method for Manufacturing Substrate with Protective Film, Method for Manufacturing Substrate with Resist Pattern, and Method for Manufacturing Semiconductor Device)

A protective film of the present invention is a baked product of a coating film formed of a protective-film forming composition.

The method for manufacturing a substrate with a protective film of the present invention includes a step of applying the protective-film forming composition of the present invention on a stepped semiconductor substrate and baking the protective-film forming composition to form a protective film.

The method for manufacturing a substrate with a resist pattern according to the present invention includes the following steps (1) and (2).

Step (1): a step of applying the protective-film forming composition of the present invention on a semiconductor substrate and baking the protective-film forming composition to form a protective film as a resist underlayer film

Step (2): a step of forming a resist film directly on the protective film or over the protective film, with another layer interposed between the resist film and the protective film, and exposing and developing the resist film to form a resist pattern

A method for manufacturing a semiconductor device according to the present invention includes the following processes (A) to (D).

Process (A): a process of forming a protective film by using the protective-film forming composition of the present invention on a semiconductor substrate having a surface on which an inorganic film is formed

Process (B): a process of forming a resist pattern directly on the protective film or over the protective film, with another layer interposed between the resist pattern and the protective film

Process (C): a process of dry etching the protective film by using the resist pattern as a mask to expose a surface of the inorganic film

Process (D): a process of wet etching the inorganic film by using the protective film after dry etching as a mask with a semiconductor wet etching solution

Examples of the semiconductor substrate onto which the protective-film forming composition (resist underlayer film-forming composition) of the present invention is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a silicon oxynitride film, a boro-phospho silicate glass (BPSG) film, a titanium nitride film, a titanium oxynitride film, a tungsten nitride film, a gallium nitride film, and a gallium arsenide film.

The semiconductor substrate may be a stepped substrate in which so-called vias (holes), trenches (grooves), and the like are formed. For example, a via has a substantially circular shape when viewed from the top, the diameter of the substantially circular shape is, for example, 0.5 nm to 50 nm, and the depth is 50 nm to 500 nm, and a trench has, for example, a width (a recess on the substrate) of 0.5 nm to 50 nm, and a depth of 50 nm to 500 nm. The protective-film forming composition (resist underlayer film-forming composition) of the present invention can be embedded even in the stepped substrate as described above without a defect such as a void. It is an important characteristic that there are no defects such as voids for the next step (wet etching and dry etching of semiconductor substrate, the formation of a resist pattern) of semiconductor manufacturing.

The protective-film forming composition of the present invention is applied onto such a semiconductor substrate by an appropriate application method such as a spinner or a coater. Thereafter, the protective film is formed by baking using heating means such as a hot plate. Baking conditions are appropriately selected from a baking temperature of 100°C to 400°C and a baking time of 0.3 minutes to 60 minutes. The baking temperature is preferably 120°C to 350°C and the baking time is preferably 0.5 minutes to 30 minutes, and the baking temperature is more preferably 150°C to 300°C, and the baking time is more preferably 0.8 minutes to 10 minutes. The film thickness of the formed protective film is, for example, 0.001 µm to 10 µm, preferably 0.002 µm to 1 µm, and more preferably 0.005 µm to 0.5 µm. In a case where the temperature during the baking is lower than the above range, crosslinking is insufficient, and it may be difficult to obtain resistance of the formed protective film to a resist solvent or a basic hydrogen peroxide aqueous solution. On the other hand, when the temperature at the time of baking is higher than the range, the protective film may be decomposed by heat.

A resist film is formed directly on the protective film thus formed or over the protective film, with another layer interposed between the resist film and the protective film, and the resist film is then exposed and developed to form a resist pattern.

The exposure is performed through a mask (reticle) for forming a predetermined pattern, and for example, i-line, KrF excimer laser, ArF excimer laser, extreme ultraviolet rays (EUV), or electron beams (EB) are used. An alkaline developer is used for development, and a development temperature is appropriately selected from 5°C to 50°C, and a development time is appropriately selected from 10 seconds to 300 seconds. As the alkaline developer, for example, it is possible to use alkaline aqueous solutions such as aqueous solutions of inorganic alkalis such as sodium hydroxide, potassium hydroxide, sodium carbonate, sodium silicate, sodium metasilicate, and ammonia solutions, primary amines such as ethylamine and n-propylamine, secondary amines such as diethylamine and din-butylamine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, cyclic amines such as pyrrole and piperidine, and other alkaline aqueous solutions. Further, an alcohol such as isopropyl alcohol, or a surfactant such as a nonionic surfactant can be added in an appropriate amount to the aqueous solution of an alkali and used. Among these, as the developers, it is preferable to use quaternary ammonium salts, and still more preferable to use tetramethylammonium hydroxide and choline. Furthermore, surfactants or other additives can be added to these developers. It is also possible to use a method in which development is performed with an organic solvent such as butyl acetate in place of the alkaline developer and a portion where the alkali dissolution rate of the photoresist is not improved is developed.

Next, the protective film is subjected to dry etching using the formed resist pattern as a mask. At that time, when the inorganic film is formed on the surface of the used semiconductor substrate, the surface of the inorganic film is exposed, and when the inorganic film is not formed on the surface of the used semiconductor substrate, the surface of the semiconductor substrate is exposed.

Further, a desired pattern is formed by wet etching using a semiconductor wet etching solution using the protective film (also the resist pattern when the resist pattern remains on the protective film) after dry etching as a mask.

As the semiconductor wet etching solution, a general chemical liquid for etching a semiconductor wafer can be used, and for example, both an acidic substance and a basic substance can be used.

Examples of the substance exhibiting acidity include hydrogen peroxide, hydrofluoric acid, ammonium fluoride, acidic ammonium fluoride, ammonium hydrogen fluoride, buffered hydrofluoric acid, hydrochloric acid, nitric acid, sulfuric acid, phosphoric acid, and a mixed solution thereof.

Examples of the substance exhibiting basicity include basic hydrogen peroxide water obtained by mixing an organic amine such as ammonia, sodium hydroxide, potassium hydroxide, sodium cyanide, potassium cyanide, or triethanolamine with hydrogen peroxide water to make the pH basic. Specific examples thereof include SC-1 (ammonia-hydrogen peroxide solution). In addition, a substance capable of adjusting a pH to a basic pH, for example, a substance capable of finally adjusting a pH to a basic pH by mixing urea with hydrogen peroxide water and causing thermal decomposition of urea by heating to generate ammonia, can be used as a chemical liquid for wet etching.

Among them, acidic hydrogen peroxide water or basic hydrogen peroxide water is preferable.

These chemical liquids may contain an additive such as a surfactant.

The temperature during use of the semiconductor wet etching solution is desirably 25°C to 90°C, and more desirably 40°C to 80°C. The wet etching time is desirably 0.5 minutes to 30 minutes, and more desirably 1 minute to 20 minutes.

### Examples

Next, the contents of the present invention will be specifically described with reference to Examples, but the present invention is not limited thereto.

The weight-average molecular weights of the polymers shown in Examples below are results measured by gel permeation chromatography (hereinafter, abbreviated as GPC). In the measurement, a GPC apparatus manufactured by Tosoh Corporation was used, and measurement conditions and the like are as follows:
GPC column: Shodex (registered trademark) KF803L, Shodex (registered trademark) KF802, Shodex (registered trademark) KF801 (manufactured by Resonac Holdings Corporation)
Column temperature: 40°C
Solvent: Tetrahydrofuran (THF)
Flow rate: 1.0 ml/min
Standard sample: Polystyrene (manufactured by Tosoh Corporation)

### <Synthesis Example 1>

A reaction flask was charged with a mixture prepared by addition of 123.8 g of propylene glycol monomethyl ether to 90.0 g of diglycidyl methyl isocyanurate (product name: MeDGIC, 29.9 weight% propylene glycol monomethyl ether solution, manufactured by Shikoku Chemicals Corporation), 17.09 g of succinic acid (manufactured by Tokyo Chemical Industry Co., Ltd.), and 2.73 g of tetrabutylphosphonium bromide (manufactured by Hokko Chemical Industry Co., Ltd.), and heated and stirred at 100°C for 16 hours in a nitrogen atmosphere. The resultant reaction product was found to correspond to the following formula (1o), and to have a weight-average molecular weight Mw of 954 as measured by GPC in terms of polystyrene.

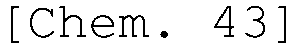

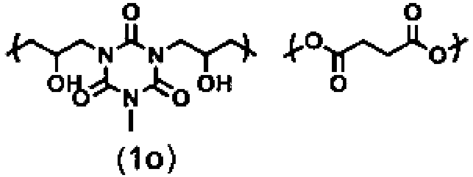

### <Example 1>

To 4.78 g of a solution of a reaction product obtained by the method described in Synthesis Example 12 of WO2020/026834 (a copolymer corresponding to the following formula (1n) and having a weight average molecular weight of 4500 as measured in terms of polystyrene by GPC) (solid content: 16.5 mass%), 0.030 g of pyridinium trifluoromethanesulfonate (manufactured by Tokyo Chemical Industry Co., Ltd.), 0.040 g of tannic acid (a compound represented by the following formula (I), manufactured by FUJIFILM Wako Pure Chemical Corporation), 0.00079 g of a surfactant (product name: MEGAFACE (registered trademark) R-40, manufactured by DIC Corporation), 1.9 g of propylene glycol monomethyl ether acetate, and 13.2 g of propylene glycol monomethyl ether were added to prepare a solution. The solution was filtered through a polyethylene microfilter having a pore size of 0.02 µm to prepare a protective-film forming composition. 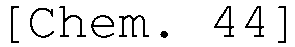 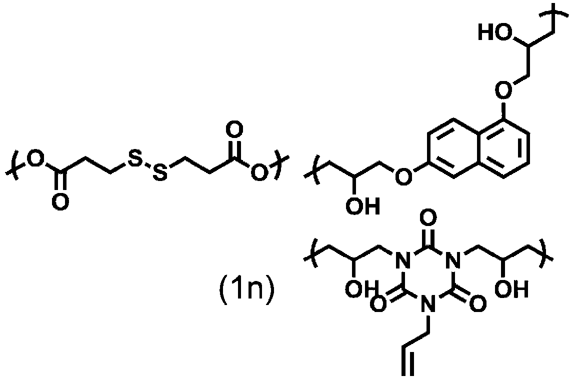 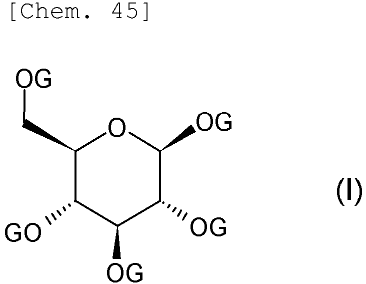
wherein G each independently represents a hydrogen atom or a monovalent group represented by the following formula (II). 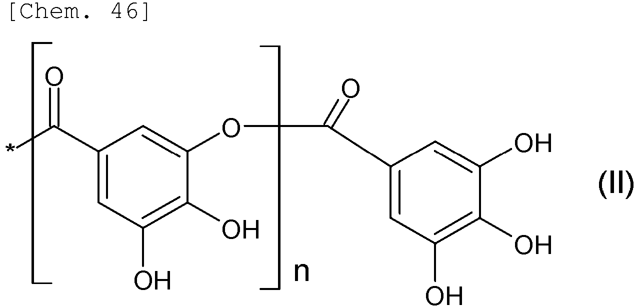
wherein n represents an integer of 0 to 3, provided that the number of benzene rings in the formula (I) is 4 or more and 17 or less, and * represents a bond.

An example of the structure of the tannic acid represented by the formula (I) is shown in the following formula (III).

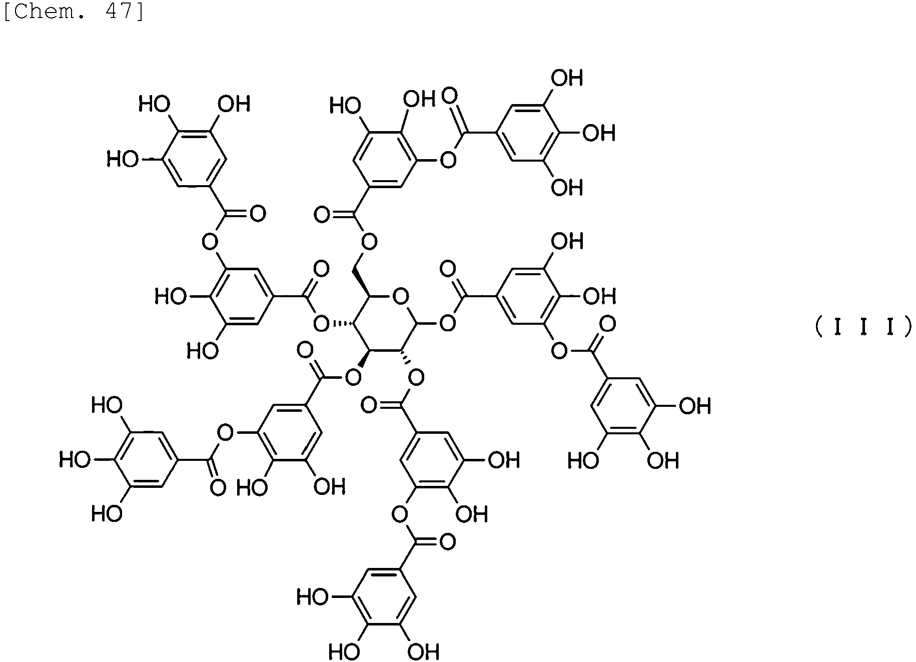

The formula (III) is a compound in which all of G in the formula (I) are monovalent groups represented by the formula (II) and all of n in the formula (II) are 1.

### <Example 2>

To 4.57 g of a solution of a reaction product obtained by the method described in Synthesis Example 12 of WO2020/026834 (a copolymer corresponding to the formula (1n) and having a weight average molecular weight of 4500 as measured in terms of polystyrene by GPC) (solid content: 16.5 mass%), 0.028 g of pyridinium trifluoromethanesulfonate (manufactured by Tokyo Chemical Industry Co., Ltd.), 0.076 g of tannic acid (a compound represented by the formula (I), manufactured by FUJIFILM Wako Pure Chemical Corporation), 0.00076 g of a surfactant (product name: MEGAFACE (registered trademark) R-40, manufactured by DIC Corporation), 1.9 g of propylene glycol monomethyl ether acetate, and 13.4 g of propylene glycol monomethyl ether were added to prepare a solution. The solution was filtered through a polyethylene microfilter having a pore size of 0.02 µm to prepare a protective-film forming composition.

### <Example 3>

To 4.84 g of a solution containing the reaction product obtained in Synthesis Example 1 (solid content: 16.3 mass%), 0.030 g of pyridinium trifluoromethanesulfonate (manufactured by Tokyo Chemical Industry Co., Ltd.), 0.040 g of tannic acid (a compound represented by the formula (I), manufactured by FUJIFILM Wako Pure Chemical Corporation), 0.00079 g of a surfactant (product name: MEGAFACE (registered trademark) R-40, manufactured by DIC Corporation), 1.9 g of propylene glycol monomethyl ether acetate, and 13.2 g of propylene glycol monomethyl ether were added to prepare a solution. The solution was filtered through a polyethylene microfilter having a pore size of 0.02 µm to prepare a protective-film forming composition.

### <Example 4>

To 4.63 g of a solution containing the reaction product obtained in Synthesis Example 1 (solid content: 16.3 mass%), 0.028 g of pyridinium trifluoromethanesulfonate (manufactured by Tokyo Chemical Industry Co., Ltd.), 0.076 g of tannic acid (a compound represented by the formula (I), manufactured by FUJIFILM Wako Pure Chemical Corporation), 0.00076 g of a surfactant (product name: MEGAFACE (registered trademark) R-40, manufactured by DIC Corporation), 1.9 g of propylene glycol monomethyl ether acetate, and 13.3 g of propylene glycol monomethyl ether were added to prepare a solution. The solution was filtered through a polyethylene microfilter having a pore size of 0.02 µm to prepare a protective-film forming composition.

### <Comparative Example 1>

To 5.01 g of a solution of a reaction product obtained by the method described in Synthesis Example 12 of WO2020/026834 (a copolymer corresponding to the formula (1n) and having a weight average molecular weight of 4500 as measured in terms of polystyrene by GPC) (solid content: 16.5 mass%), 0.031 g of pyridinium trifluoromethanesulfonate (manufactured by Tokyo Chemical Industry Co., Ltd.), 0.00083 g of a surfactant (product name: MEGAFACE (registered trademark) R-40, manufactured by DIC Corporation), 13.0 g of propylene glycol monomethyl ether, and 1.91 g of propylene glycol monomethyl ether acetate were added to prepare a solution. The solution was filtered through a polyethylene microfilter having a pore size of 0.02 µm to prepare a protective-film forming composition.

### <Comparative Example 2>

To 4.78 g of a solution of a reaction product obtained by the method described in Synthesis Example 12 of WO2020/026834 (a copolymer corresponding to the formula (1n) and having a weight average molecular weight of 4500 as measured in terms of polystyrene by GPC) (solid content: 16.5 mass%), 0.030 g of pyridinium trifluoromethanesulfonate (manufactured by Tokyo Chemical Industry Co., Ltd.), 0.040 g of gallic acid hydrate (a hydrate of a compound represented by the following formula (3), manufactured by Tokyo Chemical Industry Co., Ltd.), 0.00079 g of a surfactant (product name: MEGAFACE (registered trademark) R-40, manufactured by DIC Corporation), 13.2 g of propylene glycol monomethyl ether, and 1.9 g of propylene glycol monomethyl ether acetate were added to prepare a solution. The solution was filtered through a polyethylene microfilter having a pore size of 0.02 µm to prepare a protective-film forming composition.

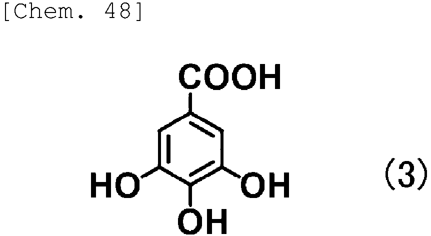

### <Comparative Example 3>

To 4.78 g of a solution of a reaction product obtained by the method described in Synthesis Example 12 of WO2020/026834 (a copolymer corresponding to the formula (1n) and having a weight average molecular weight of 4500 as measured in terms of polystyrene by GPC) (solid content: 16.5 mass%), 0.030 g of pyridinium trifluoromethanesulfonate (manufactured by Tokyo Chemical Industry Co., Ltd.), 0.040 g of (2,3,4-trihydroxyphenyl)(3,4,5-trihydroxyphenyl)methanone (a compound represented by the following formula (2), 2,3,3',4,4',5'-hexahydroxybenzophenone, also referred to as Exifone or HHBP, manufactured by Tokyo Chemical Industry Co., Ltd.), 0.00079 g of a surfactant (product name: MEGAFACE (registered trademark) R-40, manufactured by DIC Corporation), 1.9 g of propylene glycol monomethyl ether acetate, and 13.2 g of propylene glycol monomethyl ether were added to prepare a solution. The solution was filtered through a polyethylene microfilter having a pore size of 0.02 µm to prepare a protective-film forming composition.

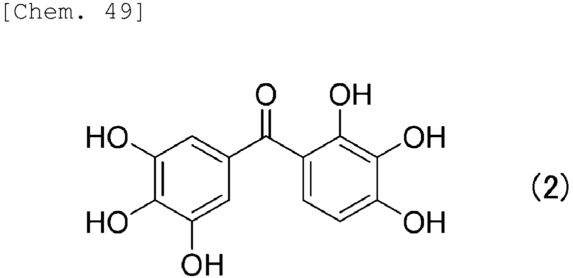

### <Comparative Example 4>

To 4.57 g of a solution of a reaction product obtained by the method described in Synthesis Example 12 of WO2020/026834 (a copolymer corresponding to the formula (1n) and having a weight average molecular weight of 4500 as measured in terms of polystyrene by GPC) (solid content: 16.5 mass%), 0.028 g of pyridinium trifluoromethanesulfonate (manufactured by Tokyo Chemical Industry Co., Ltd.), 0.076 g of HHBP (manufactured by Tokyo Chemical Industry Co., Ltd.), 0.00076 g of a surfactant (product name: MEGAFACE (registered trademark) R-40, manufactured by DIC Corporation), 1.91 g of propylene glycol monomethyl ether acetate, and 13.4 g of propylene glycol monomethyl ether were added to prepare a solution. The solution was filtered through a polyethylene microfilter having a pore size of 0.02 µm to prepare a protective-film forming composition.

### (Formation of Coating Film)

### [Test of Resistance to Basic Hydrogen Peroxide Aqueous Solution]

Protective films (coating films) were formed using each of the protective-film forming compositions prepared in Examples 1 to 4 and Comparative Examples 1 to 4, and a test of resistance to a basic hydrogen peroxide aqueous solution was performed.

The outline of the resistance test is shown in Figs. 1A to 1D.

As shown in Fig. 1A, as a semiconductor substrate, a silicon substrate 1 was used which had a titanium nitride film (TiN) of 5 nm in film thickness formed on the surface and had a step (width 37 nm, depth 240 nm). Fig. 1A is a part of a silicon substrate, and a plurality of the steps are provided.

Subsequently, as shown in Fig. 1B, each of the protective-film forming compositions prepared in Examples 1 to 4 and Comparative Examples 1 to 4 was applied to the silicon substrate 1, and heated at 220°C for 60 seconds to form coating films (protective films 2).

Next, as shown in Fig. 1C, the formed protective film 2 was dry-etched with a N₂/O₂ mixed gas (N₂/O₂ volume ratio = 200/10) for 60 seconds using a dry etching apparatus (RIE-200NL, manufactured by Samco Inc.). At this time, the protective film 2 was dry-etched so that TiN on the wall surface in the step was exposed.

Next, 20 mL of a 28 mass% ammonia aqueous solution, 80 mL of a 33 mass% hydrogen peroxide aqueous solution, and 400 mL of ultrapure water were mixed to prepare a basic hydrogen peroxide aqueous solution. The dry-etched silicon substrate 1 described above was immersed in a basic hydrogen peroxide aqueous solution heated to 60°C for 100 seconds to perform wet etching. Thereafter, the silicon substrate 1 was washed with water and dried, and the state of the protective film 2 was observed with a field emission scanning electron microscope (Regulus (registered trademark) 8240) manufactured by Hitachi High-Tech Corporation. As shown in Fig. 1D, TiN was scraped to a deeper position in the step than the protective film by wet etching. The results of the test of resistance to a basic hydrogen peroxide aqueous solution are shown in Table 1. "∘" in Table 1 indicates a state in which peeling was not observed in the protective film after immersion as in Comparative Example 3, and "×" indicates a state in which peeling was observed and deteriorated in a part or all of the protective film after immersion as compared with Comparative Example 3.

**[Table 1]**

| Evaluation results of chemical resistance test (based on Comparative Example 3) | | | | | | | |
|---|---|---|---|---|---|---|---|
| Example 1 | Example 2 | Example 3 | Example 4 | Comparative Example 1 | Comparative Example 2 | Comparative Example 3 | Comparative Example 4 |
| ○ | ○ | ○ | ○ | × | ○ | ○ | ○ |

### [Test of Optical Parameters]

Each of the protective-film forming compositions prepared in Examples 1 to 4 and Comparative Examples 1 to 4 was applied onto a silicon wafer with a spinner. Baking was performed on a hot plate at 220°C for 1 minute to form a resist underlayer film (film thickness: 50 nm). Then, an n value (a refractive index) and a k value (an attenuation coefficient or an absorption coefficient) of these films at a wavelength of 193 nm and a wavelength of 248 nm were measured using a spectroscopic ellipsometer (J.A. Woollam Company, VUV-VASE VU-302). The results are shown in Table 2.

**[Table 2]**

| | n/k@193 nm | n/k@248 nm |
|---|---|---|
| Example 1 | 1.83/0.25 | 1.74/0.14 |
| Example 2 | 1.80/0.25 | 1.73/0.14 |
| Example 3 | 1.88/0.24 | 1.62/0.11 |
| Example 4 | 1.86/0.24 | 1.63/0.11 |
| Comparative Example 1 | 1.84/0.27 | 1.74/0.14 |
| Comparative Example 2 | 1.85/0.24 | 1.74/0.14 |
| Comparative Example 3 | 1.83/0.25 | 1.74/0.14 |
| Comparative Example 4 | 1.82/0.26 | 1.75/0.15 |

### [Measurement of Sublimate Quantity]

Measurement of the sublimate quantity was performed using a sublimate quantity measuring apparatus described in WO 2007/111147 A.

The protective-film forming compositions prepared in Examples 1 to 4 and Comparative Examples 1 to 4 were applied to a silicon wafer substrate having a diameter of 4 inches by a spin coater at 1500 rpm for 60 seconds. The wafer applied with the protective-film forming composition was set in the sublimate measuring apparatus integrated with a hot plate adjusted to 220°C, and baked for 60 seconds, and the sublimate was collected on a QCM (Quartz Crystal Microbalance) sensor, that is, a quartz resonator on which an electrode was formed. The QCM sensor can measure a small amount of mass change by utilizing a property that a frequency of the quartz resonator changes (lowers) according to a mass of a sublimate attached to a surface (electrode) of the quartz resonator.

The detailed measurement procedure is as follows. The temperature of the hot plate of the sublimate quantity measuring apparatus was raised to 220°C, the pump flow rate was set to 1 m³/s, and the apparatus was left to stand for the first 60 seconds for stabilization of the apparatus. Immediately thereafter, the wafer coated with the protective-film forming composition was rapidly placed on a hot plate from the slide port, and the sublimate was collected at the time point of 120 seconds (60 seconds) from the time point of 60 seconds after the wafer was placed. A flow attachment (detection portion) serving as a connection between the QCM sensor and the collection funnel portion of the sublimate quantity measuring apparatus is used without attaching a nozzle thereto. Therefore, an air stream flows in through a flow path (diameter: 32 mm) of a chamber unit having a distance from the sensor (quartz resonator) of 30 mm, without being narrowed. For the QCM sensor, a material containing silicon and aluminum as main components (AlSi (with Ti deposited on the surface)) was used as an electrode, a sensor in which the diameter (sensor diameter) of the quartz resonator was 14 mm, the electrode diameter on the surface of the quartz resonator was 5 mm, and the resonance frequency was 9 MHz, was used.

A serial cable through which the measured values can be directly taken into a personal computer was connected, and dedicated software was installed, so that the QCM sensor can measure the sublimate quantity in real time in each measurement. The film thickness of the coating film of the wafer used for measuring the sublimate quantity was 100 nm.

The obtained frequency change was converted from the eigenvalue of the quartz resonator used for measurement to grams, and the relationship between the sublimate quantity of one wafer on which the protective-film forming composition was applied and the lapse of time was clarified. The first 60 seconds are a time zone during which the wafer was left to stand for apparatus stabilization (no wafer was placed), and the measurement value from the time point of 60 seconds when the wafer was placed on the hot plate to the time point of 120 seconds is the measurement value related to the sublimate quantity of the wafer. The sublimate quantity of the protective film quantified from the sublimate quantity measuring apparatus is shown in Table 3 as a sublimate quantity ratio. The sublimate quantity is represented by a relative value obtained by converting the value in Comparative Example 3 to 1.0.

**[Table 3]**

| | Example 1 | Example 2 | Example 3 | Example 4 | Comparative Example 1 | Comparative Example 2 | Comparative Example 3 | Comparative Example 4 |
|---|---|---|---|---|---|---|---|---|
| Content of additive (mass% with respect to component (A)) | 5 | 10 | 5 | 10 | 0 | 5 | 5 | 10 |
| Content of component (B) (mass% with respect to component (A)) | 5 | 10 | 5 | 10 | 0 | 0 | 0 | 0 |
| Sublimate quantity (converting the quantity in Comparative Example 3 to 1.0) | 0.8 | 0.5 | 0.5 | 0.4 | 0.9 | 1.3 | 1.0 | 1.3 |

As shown in Table 1, the protective films formed using the protective-film forming compositions of Examples 1 to 4 to which the present invention was applied were excellent in chemical resistance. On the other hand, the protective film formed using the protective-film forming composition of Comparative Example 1 containing no additive was inferior in chemical resistance.

As shown in Table 2, it could be confirmed that the protective films formed using the protective-film forming compositions of Examples 1 to 4 to which the present invention was applied had performance without problems as an antireflection film.

As shown in Table 3, it could be confirmed that the protective films formed using the protective-film forming compositions of Examples 1 to 4 to which the present invention was applied could reduce the sublimate quantity by 20 to 60% as compared with the protective film formed using the protective-film forming composition of Comparative Example 3 in which the additive did not contain the component (B).

### Industrial Applicability

The protective-film forming composition according to the present invention provides a protective film having excellent resistance when a wet etching solution is applied in substrate processing and having a small sublimate quantity during firing.

### Reference Signs List

- 1: Silicon substrate
- 2: Protective film

## Claims

1. A protective-film forming composition against a semiconductor wet etching solution, comprising:
component (A): a film-forming component;
component (B): a compound selected from the group consisting of condensed tannin (b1) obtained by polymerizing a compound having a flavanol skeleton, hydrolyzable tannin (b2) obtained by ester-bonding an aromatic compound of gallic acid or ellagic acid to a sugar, and a flavonoid (b3) derived from a compound having a flavanone skeleton structure; and
component (C): a solvent.

2. The protective-film forming composition according to claim 1, wherein the component (B) is one or more compounds selected from the condensed tannin and the hydrolyzable tannin.

3. The protective-film forming composition according to claim 1, wherein the component (B) is the hydrolyzable tannin.

4. The protective-film forming composition according to claim 3, wherein the hydrolyzable tannin is tannic acid represented by the following formula (I): 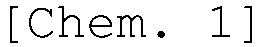 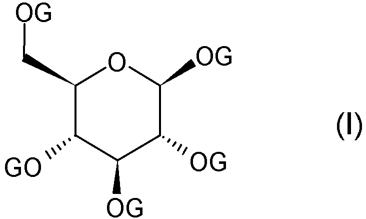
wherein G each independently represents a hydrogen atom or a monovalent group represented by the following formula (II), 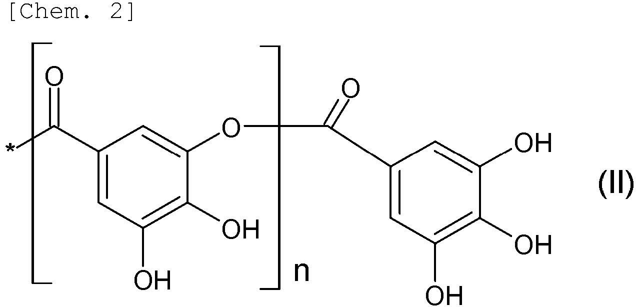
wherein n represents an integer of 0 to 3, provided that the number of benzene rings in the formula (I) is 4 or more and 17 or less, and * represents a bond.

5. The protective-film forming composition according to claim 1, further comprising component (D): a curing catalyst.

6. The protective-film forming composition according to claim 1, wherein a content of the component (B) is 0.1 to 50 mass% with respect to the mass of the solid content of the component (A).

7. A protective film against a semiconductor wet etching solution, wherein the protective film is a baked product of a coating film formed of the protective-film forming composition according to any one of claims 1 to 6.

8. A method for manufacturing a substrate with a protective film used in semiconductor manufacturing, the method comprising a step of applying the protective-film forming composition according to any one of claims 1 to 6 on a semiconductor substrate and baking the protective-film forming composition to form a protective film.

9. A method for manufacturing a substrate with a resist pattern used in semiconductor manufacturing, the method comprising steps of:
applying the protective-film forming composition according to any one of claims 1 to 6 on a semiconductor substrate and baking the protective-film forming composition to form a protective film as a resist underlayer film; and
forming a resist film directly on the protective film or over the protective film, with another layer interlayered, and exposing and developing the resist film to form a resist pattern.

10. A method for manufacturing a semiconductor device, the method comprising a step of forming a protective film using the protective-film forming composition according to any one of claims 1 to 6 on a semiconductor substrate having a surface on which an inorganic film may be formed, forming a resist pattern on the protective film, dry etching the protective film using the resist pattern as a mask to expose the inorganic film or the surface of the semiconductor substrate, and wet etching and cleaning the inorganic film or the semiconductor substrate using a semiconductor wet etching solution using the protective film after the dry etching as a mask.
